(19) Europäisches Patentamt
European Patent Office
Office européen des brevets

(11) **EP 2 290 134 A1**

(12) **EUROPÄISCHE PATENTANMELDUNG**

(43) Veröffentlichungstag:
**02.03.2011 Patentblatt 2011/09**

(21) Anmeldenummer: **09010995.0**

(22) Anmeldetag: **27.08.2009**

(51) Int Cl.:
*C25D 13/04* (2006.01)    *C25D 5/10* (2006.01)
*C25D 5/50* (2006.01)    *C25D 5/56* (2006.01)
*H01L 31/0224* (2006.01)    *H01L 21/288* (2006.01)
*C09D 5/44* (2006.01)    *H05K 3/20* (2006.01)
*C25D 1/04* (2006.01)    *C25D 1/22* (2006.01)

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**
Benannte Erstreckungsstaaten:
**AL BA RS**

(71) Anmelder: **IP Bewertungs AG**
**20354 Hamburg (DE)**

(72) Erfinder:
• **Rostami, Bardia, Dr.**
**22299 Hamburg (DE)**

• **Kruse, Jan, Dr.**
**22089 Hamburg (DE)**
• **Uelzen, Thorsten, Dr.**
**21698 Bargstedt (DE)**

(74) Vertreter: **Kloth, Matthias**
**White & Case LLP**
**Jungfernstieg 51**
**20354 Hamburg (DE)**

(54) **Verfahren zur Herstellung mindestens einer Leiterbahn auf einem Substrat**

(57)    Erfindungsgemäß ist ein Verfahren zur Herstellung mindestens einer Leiterbahn auf einem Substrat, gekennzeichnet durch die Verfahrensschritte:

a. Erstellung einer elektrisch leitfähigen Polymerstruktur mittels elektrochemischer Polymerisation auf einer strukturierten Elektrode,

b. ein erstes galvanisches Abscheiden eines ersten metallischen Stoffes auf zumindest einem Teil der Polymerstruktur, so dass eine erste Metallstruktur entsteht,

c. ein zweites galvanisches Abscheiden eines zweiten metallischen Stoffes auf zumindest einem Teil der ersten Metallstruktur, so dass eine zweite Metallstruktur entsteht und

d. ein thermisches Verbinden der ersten und/oder der zweiten Metallstruktur mit dem Substrat, wobei die mit dem Substrat verbundene Metallstruktur das Verbindungsmittel ist.

Fig. 10

**Beschreibung**

Die Erfindung betrifft ein Verfahren zur Herstellung mindestens einer Leiterbahn auf einem Substrat.

Stand der Technik:

Für die Erzeugung elektrisch leitfähiger Leiterbahnen auf Substraten sind aus dem Stand der Technik eine Vielzahl unterschiedlicher technischer Verfahren bekannt. So können elektrisch leitfähige Bahnen beispielsweise durch Maskenätzen, geeignete Druckverfahren oder Laserapplikationen auf Substrate aufgebracht werden. Die bekannten Verfahren unterscheiden sich, neben dem jeweils erforderlichen Aufwand, hauptsächlich durch die mit ihnen erzielbare Auflösung, Oberflächengüte und/oder Verfahrensgeschwindigkeit.

Ein aus dem Stand der Technik bekanntes Verfahren zur Herstellung einer Leiterbahn zeichnet sich dadurch aus, dass auf einem Substrat zunächst einer dünner Metallfilm großflächig aufgebracht wird. Auf diesem Metallfilm wird eine Photoschicht aufgebracht, die danach komplementär zu der gewünschten Struktur der Leiterbahn photochemisch entfernt wird. Die in diesem komplementären Bereich freigelegte Metallstruktur wird daraufhin weggeätzt. Abschließend wird der mit der verbleibenden Metallstruktur in Verbindung stehende Photolack, beispielsweise durch Lösen mittels eines Lösungsmittels, entfernt.

Ein weiteres Verfahren zur Metallisierung eines Substrates ist in der Druckschrift DE 11 2004 000 600 T5 beschrieben. Hiernach wird zunächst auf einem Halbleitermaterial eine erste Metallschicht aus Aluminium gesputtert. Diese Aluminiumschicht bildet den elektrischen Kontakt zu dem Substrat. Danach wird eine dünne Barrieremetallschicht über die erste Metallschicht gebildet. Diese zweite Metallschicht ist beispielsweise aus Titan-Wolfram. Abschließend wird eine dritte Schicht, beispielsweise aus Kupfer, auf die Barriereschicht durch Sputtern oder Aufdampfen abgeschieden. Die Strukturen des Metalls wurden durch Photoresist, Photolithographie und/oder durch selektives Ätzen in bekannter Weise gebildet.

Den aus dem Stand der Technik bekannten Verfahren zur Herstellung von Leiterbahnen auf einem Substrat ist gemein, dass ihre Auflösung für eine Vielzahl von Anwendungen, insbesondere für den Elektrotechnikbereich, nicht ausreichend ist.

Aufgabe:

Der Erfindung liegt die Aufgabe zugrunde, ein Verfahren bereitzustellen, mit dem bei möglichst geringem Aufwand Leiterbahnen mit hoher Auflösung auf einem Substrat herstellbar sind, wobei die Leiterbahnen zumindest teilweise mit dem Substrat elektrisch verbindbar sein soll.

Es ist von Vorteil, wenn die Leiterbahnen mit einer hohen Auflösung, insbesondere im Bereich von 5-50 Mikrometern, herstellbar sind.

Lösungsvorschlag:

Die Aufgabe der Erfindung wird erfindungsgemäß durch ein Verfahren mit den Merkmalen des Anspruchs 1 gelöst. Durch das erfindungsgemäße Verfahren ist es möglich, kostengünstig eine hochauflösende, feine und/oder schmale Leiterbahn auf einem Substrat herzustellen.

Für das Verfahren zur Herstellung mindestens einer Leiterbahn auf einem Substrat werden jeweils zeitlich nacheinander ein Polymerisationsprozess, ein Primärgalvanikprozess, ein Sekundärgalvanikprozess und ein Verbindungsprozess ausgeführt. Dabei kann zwischen zwei dieser Verfahrensschritte mindestens ein weiterer, bevorzugt ausgestalteter Verfahrensschritt ausgeführt werden.

Erfindungsgemäß ist die Herstellung einer, insbesondere elektrisch leitfähigen, Polymerstruktur mittels elektrochemischer Polymerisation (Polymerisationsprozess) auf einer strukturierten Elektrode (Strukturelektrode). Eine bevorzugte Ausgestaltung der elektrochemischen Polymerisation zur Erstellung einer leitfähigen Polymerschicht auf einer strukturierten Elektrode ist aus der deutschen Patentanmeldung DE 10 2009 010 434.8 bekannt, wobei dessen Gegenstand in vollem Umfang eine bevorzugte Ausgestaltung dieser Erfindung sein soll und ein bevorzugter Gegenstand dieser Patentanmeldung ist.

Für den Polymerisationsprozess kann mindestens eine Strukturelektrode verwendet werden, deren Oberfläche einen ersten Bereich einer vorgebbaren Struktur (Elektrodenkontaktbereich) und einen übrigen, zweiten Bereich (Elektrodenkomplementärbereich) aufweist. Bevorzugt ist der Elektrodenkontaktbereich der Strukturelektrode elektrisch leitend ausgestaltet. Der Elektrodenkomplementärbereich der Strukturelektrode kann elektrisch isolierend ausgestaltet sein. Bevorzugt ist der Elektrodenkomplementärbereich ein Isolator. Grundsätzlich ist es jedoch möglich, dass auch der Elektrodenkomplementärbereich elektrisch leitend ist. Hierbei ist es jedoch dann besonders bevorzugt, dass der Elektrodenkomplementärbereich nicht mit einem elektrischen Potential verbunden ist und/oder verbindbar ist. Es ist besonders bevorzugt, dass der Elektrodenkontaktbereich mit einem ersten Spannungspotential verbunden ist und/oder verbindbar ist. Hierzu kann der Efektrodenkontaktbereich durch elektrische Leitungsverbindungen mit einer Spannungsquelle verbunden sein. Der Elektrodenkontaktbereich und/oder der Elektrodenkomplementärbereich können jeweils in Teilbereiche unterteilt sein. Diese Teilbereiche können durch, bevorzugt schmale, Isolationsbereiche voneinander getrennt sein.

Die strukturierte Elektrode bzw. die Strukturelektrode weisen bevorzugt die vorgebbare Struktur auf. Die Struktur selbst kann von einem herzustellenden Bauteil, insbesondere von dessen herzustellenden Leiterbahnen, abgeleitet sein. Ein solches Bauteil ist beispielsweise ein Photovoltaikelement und/oder eine Solarzelle. Das Substrat kann also ein Funktionssubstrat sein. Besonders bevorzugt ist das Substrat ein Substrat und/oder Funktionssubstrat einer Solarzelle bzw. einer photovoltaischen Zelle. Photovoltaische Zelle und Solarzelle werden im Weiteren unter dem Begriff Solarzelle zusammengefasst. Eine Solarzelle kann ein Substrat mit einem p-n-Übergang aufweisen. Um Strahlungsenergie, insbesondere Sonnenlicht, in elektrische Energie umzuwandeln, ist es bevorzugt, dass der p-n-Übergang möglichst nah an einer Oberfläche des Substrates ist, auf die die Strahlung und/oder das Sonnenlicht trifft. In dem Substrat können einstrahlende Photonen bewegliche Ladungsträger (Löcher und Elektronen) erzeugen. Das Substrat kann mit den Leiterbahnen in der Weise elektrisch verbunden sein, dass die Ladungsträger zu elektrischen Schaltkreisen außerhalb der Solarzelle geleitet werden können. Dazu können auf der Frontseite und/ oder auf der Rückseite des Substrates Leiterbahnen vorgesehen sein. Die Frontseitenkontakte und/oder Rückseitenkontakte können dazu "fingerartig" ausgestaltet sein. Hierbei kann eine etwas breitere und/oder dickere Leiterbahn an der Kante des Substrates vorgesehen sein. Hiervon wegführend können auf der Front- und oder Rückseite mehrere, insbesondere parallel zueinander ausgerichtete, Leiterbahnen vorgesehen sein. Diese Leiterbahnen können auch als "Finger" bezeichnet werden. Insbesondere auf der Frontseite ist es bevorzugt, dass die Leiterbahnen, insbesondere die fingerartigen Leiterbahnen, besonders schmal ausgestaltet sind. Sofern die Solarzelle senkrecht zueinander verschachtelte Halbleiterübergänge aufweist, können die Finger auch abwechselnd zu unterschiedlichen, sammelnden Leiterbahnen führen und/oder mit diesen verbunden sein. Eine entsprechende Ausgestaltung einer solchen Kontaktmetallstruktur ist aus dem deutschen Teil der europäischen Patentanmeldung DE 11 2004 000 600 T5 bekannt. Die elektrischen Leiterbahnen weisen also eine bestimmte Struktur auf. Die einzelnen Leiterbahnen können elektrisch miteinander verbunden sein. Außerdem können auch mehrere elektrische Leiterbahnen gruppenweise elektrisch miteinander verbunden sein. Auf diese Weise können die gemeinsamen Pole einer Solarzelle elektrisch miteinander verbunden sein und/oder von unterschiedlichen elektrischen Polen, insbesondere elektrisch, getrennt sein. Eine solche Struktur der Leiterbahnen eines elektrischen Bauelements kann die vorgebbare Struktur sein. Ist es also bevorzugt, dass elektrische Leiterbahnen fingerartig miteinander verbunden sind, so ist auch die Struktur der Elektrode entsprechend anzupassen. Durch den Polymerisationsprozess kann diese Struktur an die Polymerstruktur übertragen und/oder "vererbt" werden. Grundsätzlich sind also beliebige Strukturen für die Elektrode vorgebbar.

Bei dem Polymerisationsprozess kann wenigstens ein Teil des Elektrodenkontaktbereiches in Kontakt mit einem, vorzugsweise flüssigen, ersten Elektrolyten gebracht werden. In den ersten Elektrolyten können polymerisier- und/oder vernetzbare, insbesondere niedermolekulare, Verbindungen, insbesondere Monomere, Dimere und/oder kurzkettige Bausteine von Polymeren, eingebracht sein. Der Elektrolyt kann ein vorzugsweise organisches Lösungsmittel und/oder ein in diesem Lösungsmittel gelöstes Salz enthalten, wobei der Elektrolyt so ausgewählt wird, dass die polymerisier- und oder vernetzbaren, insbesondere niedermolekularen, Verbindungen in dem Elektrolyt löslich sind. Als Lösungsmittel kann Propylencarbonat, Acetonitril, ein- oder mehrwertige Alkohole, Tetrahydrofuran oder Wasser jeweils einzeln oder in beliebiger Mischung verwendet werden. Als Salz kann Tetraethylammonium-Tetraflurobat, Tetraethylammonium-Hexaflurophospat, Tetraethylammonium-Perchlorat und/oder Poly(styrolsulfonsäure)-Natriumsalz jeweils einzeln oder in beliebiger Kombination verwendet werden. In einem besonders einfachen Fall kann die Strukturelektrode in den Elektrolyten eingetaucht werden. Die in den Elektrolyten eingebrachten und/oder gelösten, polymerisier- und/oder vernetzbaren Verbindungen können so besonders einfach elektrochemisch an dem Elektrodenkontaktbereich der Elektrode abgeschieden werden. Als in den Elektrolyten eingebrachte, insbesondere polymerisier- und/oder vernetzbare, Verbindungen können Pyrrole, 3-Alkylpyrrole, insbesondere 3-Methyl-, 3-Ethyl-, 3-Propylpyrrole, *N*-Alkylpyrrole, insbesondere *N*-Methyl-, *N*-Ethyl-, *N*-Propylpyrrole, *N*-Arylpyrrole, insbesondere *N*-Phenyl-, *N*-(4-Amino)phenyl-, *N*-(4-Methoxy)phenyl-, *N*-Naphtylpyrrole, *N*-Heteroarylpyrrole, insbesondere *N*-(3-Thienyl)-, *N*-(2-Thienyl)-, *N*-(3-Furanyl)-, *N*-(2-Furanyl)-, *N*-(3-Selenophenyl)-, *N*-(2-Selenophenyl)-, *N*-(3-Pyrrolyl)pyrrole, Thiophene, 3-Alkylthiophene, insbesondere 3-Methyl-, 3-Ethyl-, 3-Propylthiophene, Furane, 3-Alkylfurane, 3-Methyl-, 3-Ethyl-, 3-Propylfurane, Selenophene, 3-Alkylselenophene, insbesondere 3-Methyl-, 3-Ethyl-, 3-Propylselenophene, Tellurophene, Aniline, Biphenyle, Azulene, 2-(alpha-Thienyl)thiophene, 2-(alpha-(3-Alkyl)thienyl)thiophene, 2-(alpha-(3-Alkyl)thienyl)-(3-alkyl)thiophene, 2-(alpha-Thienyl)furarie, 2-(alpha-(3-Alkyl)thienyl)furane, 2-(alpha-(3-Alkyl)thienyl)-(3-alkyl)furane, 2-(alpha-Thienyl)-(3-alkyl)furane, 2-(alpha-Thienyl)pyrrole, 2-(alpha-(3-Alkyl)thienyl)pyrrole, 2-(alpha-(3-Alkyl)thienyl)-(3-alkyl)pyrrole, 2-(alpha-Thienyl)-(3-alkyl)pyrrole, 2-(alpha-Furanyl)pyrrole, 2-(alpha-(3-Alkyl)furanyl)pyrrole, 2-(alpha-(3-Alkyl)furanyl)-(3-alkyl)pyrrole, 2-(alpha-Furanyl)-(3-alkyl)pyrrole, 2-(alpha-Pyrrolyl)pyrrole, 2-(alpha-(3-Alkyl)pyrrolyl)pyrrole, 2-(alpha-(3-Alkyl)pyrrolyl)-(3-alkyl)pyrrole, 2-(alpha-pyrrolyl)-(3-alkyl)pyrrole, 2-(alpha-Selenophenyl)selenophene, 2-(alpha-(3-Alkyl)selenophenyl)selenophene, 2-(alpha-(3-Alkyl)selenophenyl)-(3-alkyl)selenophene, 2-(alpha-Thienyl)selenophene, 2-(alpha-(3-Alkyl)thienyl)selenophene, 2-(alpha-(3-Alkyl)thienyl)-(3-alkyl)selenophene, 2-(alpha-Thienyl)-(3-alkyl)selenophene, 2-(alpha-Selenophenyl)furane, 2-(alpha-(3-Alkyl)selenophenyl)furane, 2-(alpha-(3-Alkyl)selenophenyl)-(3-alkyl)furane, 2-(alpha-Selenophenyl)-(3-alkyl)furane, 2-(alpha-Selenophenyl)pyrrole, 2-(alpha-(3-Alkyl)seienophenyl)pyrrole, 2-(alpha-(3-Alkyl)selenophenyl)-(3-alkyl)pyrrole, 2-(alpha-Selenophenyl)-(3-alkyl)pyrrole, Thienothiophene, Thienofurane, Thienoselenophene, Thienopyrrole, 2-Phenylthiophene, 2-Phenylfurane, 2-Phenylpyrrole, 2-Phenylselenophene, 2-Phenyltellurophene, *N*-Vinylcarbazol, *N*-Ethynylcarbazol, 3,4-Ethylendioxythiophene, 2-(alpha-(3,4-Ethylendioxy)thienyl)thiophene, 2-(alpha-(3,4- Ethylendioxy) thienyl)- 3,4- Ethylendioxythiophene, 2-(alpha-(3,4-Ethylendioxy)thienyl)-(3-alkyl)thiophene, 2-(alpha-(3,4-Ethylendioxy)thienyl)furane, 2-(alpha-(3,4-Ethylendioxy)thienyl)-(3-alkyl)furane, 2-(alpha-(3,4-Ethylendioxy)thienyl)pyrrole, 2-(alpha-(3,4-Ethylendioxy)thienyl)-(3-alkyl)pyrrole, 2-(alpha-(3,4-Ethylendioxy)thienyl)selenophene oder 2-(alpha-(3,4-Ethylendioxy)thienyl)-(3-alkyl)selenophene jeweils einzeln oder in beliebiger Kombination oder als oligomere Monomereinheiten verwendet werden.

Bei dem Polymerisationsprozess kann über die Strukturelektrode ein erster Stromfluss durch den ersten Elektrolyten erzeugt werden. Hierbei kann auf den mit dem ersten Elektrolyten in Kontakt gebrachten Elektrodenkontaktbereich ein leitfähiger Polymerfilm der vorgegebenen Struktur gebildet und/oder abgeschieden werden, nämlich die Polymerstruktur. Bevorzugt wird dazu eine Gegenelektrode mit dem Elektrolyten in Kontakt gebracht. Die Gegenelektrode kann mit einem elektrischen Potential (Gegenelektrodenpotential) verbunden sein, dessen Potential von dem ersten Spannungspotential abweicht.

Vor, während und/oder nach dem in Kontakt bringen des wenigstens einen Teils des Elektrodenkontaktbereiches mit dem ersten Elektrolyten kann der Elektrodenkontaktbereich mit dem ersten Spannungspotential und/oder die Gegenelektrode mit einem von dem ersten Spannungspotential abweichenden Spannungspotential (Gegenspannungspotential) und/oder der Elektrodenkomplementärbereich mit dem Gegenspannungspotential verbunden sein. Der Polymerisationsprozess zeichnet sich auch dadurch aus, dass über die Strukturelektrode ein erster Stromfluss durch den ersten Elektrolyten erzeugt wird. Dazu kann in dem ersten Elektrolyten ein elektrisches Feld ausgebildet sein. Dieses Feld kann durch einen elektrischen Potentialunterschied verursacht sein. Insbesondere kann der erste Stromfluss durch ein elektrisches Feld verursacht worden sein, dass sich zwischen dem ersten Spannungspotential und bevorzugt dem Gegenspannungspotential ausbildet. Elektrische Ladungsträger können also durch den ersten Elektrolyten und/oder durch den Elektrodenkontaktbereich der Strukturelektrode geleitet werden. Durch den Elektrodenkontaktbereich und/oder den Elektrolyten kann also ein erster Stromfluss entstehen. Mit anderen Worten kann ein Strom durch den ersten Elektrolyten und den Elektrodenkontaktbereich der Strukturelektrode (und in diesem Sinne auch über die Strukturelektrode) fließen.

Es ist erfindungsgemäß, dass auf dem mit dem ersten Elektrolyten in Kontakt gebrachten Elektrodenkontaktbereich ein leitfähiger Polymerfilm der vorgegebenen Struktur gebildet wird (Polymerstruktur). Die Bildung des Polymerfilms und/oder der Polymerstruktur erfolgt bevorzugt durch eine Polymerisation der in den ersten Elektrolyten eingebrachten polymerisier- und/oder vernetzbaren Verbindungen. Unter einer Polymerisation kann eine chemische Reaktion verstanden werden, bei der Verbindungen zu einem Makromolekül vereinigt werden. Diese Verbindungen können die polymerisier- und/oder vernetzbaren Verbindungen sein, die in den ersten Elektrolyten eingebracht sind. Ein polymerisiertes Makromolekül kann die im Wesentlichen gleiche chemische Zusammensetzung aufweisen, wie die Verbindungen, aus denen es synthetisiert und/oder hergestellt wurde. Das Makromolekül kann aber auch eine andere Molekülstruktur aufweisen. Für die Polymerisation kann es vorteilhaft sein, wenn die polymerisier- und/oder vernetzbaren Verbindungen Doppelbindungen aufweisen. Denn diese Doppelbindungen können durch Energiezufuhr "aufgeklappt" werden. Diese Energiezufuhr kann an die polymerisier- und/oder vernetzbaren Verbindungen durch den ersten Stromfluss erfolgen. Diejenigen Verbindungen der polymerisier- und/oder vernetzbaren Verbindungen, die durch die Energiezufuhr bzw. durch den Stromfluss eine derart "aufgeklappte" Doppelbindung aufweisen, können sich zu Molekülketten und/oder Makromolekülen zusammenschließen. Auf diese Weise kann ein, insbesondere ein leitfähiger, Polymerfilm gebildet werden. Es ist bevorzugt, dass der Stromfluss über den Elektrodenkontaktbereich durch den Elektrolyten erfolgt. Deshalb polymerisieren die polymerisier- und/oder vernetzbaren Verbindungen aus dem ersten Elektrolyten auch vorzugsweise an dem Elektrodenkontaktbereich und/oder in dessen unmittelbarer Nähe. Mit anderen Worten: Da der erste Elektrolyt zumindest teilweise in Kontakt mit dem Elektrodenkontaktbereich gebracht wird und die Polymerisation der polymerisier und/oder vernetzbaren Verbindungen somit bevorzugt an dem Elektrodenkontaktbereich stattfinden, scheidet sich ein Polymerfilm, im Wesentlichen auch nur, an dem Elektrodenkontaktbereich ab. Die polymerisier- und/oder vernetzbaren Verbindungen aus dem ersten Elektrolyten werden also bevorzugt an dem Elektrodenkontaktbereich abgeschieden, wobei besonders bevorzugt eine elektrochemische Polymerisation an der Kontaktfläche stattfindet.

Eine bevorzugte Ausgestaltung des Verfahrens zeichnet sich ferner dadurch aus, dass der sich beim Abscheiden der polymerisier- und/oder vernetzbaren Verbindungen bildende Polymerfilm durch Ionen oder Salze des Elektrolyten dotiert wird, so dass der Polymerfilm leitfähig wird. Eine bevorzugte Ausgestaltung des Verfahrens zeichnet sich auch dadurch aus, dass das erste Spannungspotential in der Weise gewählt ist, dass der Elektroderikontaktbereich eine Kathode ist. Das Gegenspannungspotential kann hierzu in der Weise ausgewählt sein, dass die Gegenelektrode eine Anode ist.

Da die gebildete Polymerstruktur beim Abscheiden durch Ionen des ersten Elektrolyten dotiert sein kann, kann der erste Elektrolyt die Materialeigenschaften der Polymerstruktur direkt beeinflussen. Die Leitfähigkeit der Polymerstruktur kann somit stark von der Menge der Ionen in dem ersten Elektrolyten abhängen. Um die Leitfähigkeit der Polymerstruktur zu verringern oder zu erhöhen, kann die mit der Polymerstruktur beschichtete beziehungsweise verbundene Elektrode nach dem Polymerisationsprozess und vor dem Galvanikprozess zusammen mit einer Gegenelektrode in einen Elektrolyten getaucht werden, der neben dem Lösungsmittel nur ein Salz und/oder keine polymerisier- und/oder vernetzbaren Verbindungen enthält.

Durch Anlegen einer Spannung zwischen der Strukturelektrode und der Gegenelektrode kann die Menge der Ionen in der Polymerstruktur verändert werden. Bei einem Anlegen einer Spannung in umgekehrter Richtung (im Vergleich zu der Spannung beim Polymerisationsprozess) kann die Menge der Ionen in der Polymerstruktur verringert werden. Damit kann die Leitfähigkeit der Polymerstruktur gesteuert werden. Grundsätzlich kann die Leitfähigkeit durch die elektrischen Eigenschaften der polymerisier- und/oder vernetzbaren Verbindungen begrenzt sein.

Die Veränderung der Leitfähigkeit der Polymerstruktur kann auch auf der Polymerstruktur ortabhängig ausgeführt werden. Für die nachfolgenden Galvanikprozesse ist durch die steuerbare Veränderbarkeit der Leitfähigkeit der Strom durch die Polymerstruktur ortabhängig bestimmbar und/oder das relative ortsabhängige Verhältnis der Ströme durch die Polymerstruktur bestimmbar. Auf diese Weise ist ein ortsabhängiges, relatives Dickeverhältnis des abzuscheidenden Metalls bestimmbar und/oder steuerbar. So kann die Dicke der galvanisch abzuscheidenden Schicht relativ und/oder ortsabhängig steuerbar sein.

Durch den Polymerisationsprozess kann also eine, insbesondere elektrisch leitfähige Polymerstruktur auf der Elektrode abgeschieden werden. Die Polymerstruktur kann dazu die gleiche Struktur aufweisen, wie die des Elektrodenkontaktbereiches. Dies kann dadurch erreicht werden, dass die bevorzugt elektrochemische Polymerisation an dem Kontaktbereich zwischen dem Elektrodenkontaktbereich und dem ersten Elektrolyt stattfindet.

Es ist bevorzugt, dass der Polymerfilm nur eine sehr geringe Dicke, insbesondere eine Dicke bis 50 mm, insbesondere von 0,1 nm bis 1 mm, vorzugsweise von 1 $\mu$m bis 100 m, besonders bevorzugt von 20 nm bis 500 nm, aufweist.

Neben dem Polymerisationsprozess zeichnet sich das Verfahren zur Herstellung mindestens einer Leiterbahn auf einem Substrat auch durch ein erstes galvanisches Abscheiden eines ersten metallischen Stoffes (Primärgalvanikprozess) auf zumindest einem Teil der Polymerstruktur aus, so dass eine erste Metallstruktur entsteht.

Außerdem zeichnet sich das Verfahren zur Herstellung einer Leiterbahn auf einem Substrat auch durch ein zweites galvanisches Abscheiden eines zweiten metallischen Stoffes (Sekundärgalvanikprozess) auf zumindest einem Teil der ersten Metallstruktur aus, so dass eine zweite Metallstruktur entsteht.

Für die weitere Beschreibung wird die zweite Metallstruktur als Kontaktmetallstruktur oder als zweite metallische Schicht bezeichnet und die erste Metallstruktur lediglich als Metallstruktur oder als erste metallische Schicht bezeichnet.

Der Primärgalvanikprozess wird vorzugsweise nach dem Polymerisationsprozess ausgeführt. Für den Primärgalvanikprozess kann wenigstens ein Teil der Polymerstruktur in Kontakt mit einem, vorzugsweise flüssigen, zweiten Elektrolyt gebracht werden. Hierbei kann in den zweiten Elektrolyten ein erster metallischer Stoff, insbesondere ein Übergangsmetall, vorzugsweise Kupfer, eingebracht sein. Der zweite Elektrolyt kann also einen metallischen Stoff aufweisen. Als erster metallischer Stoff kommen vorzugsweise diejenigen Stoffe in Betracht, die elektrisch leitfähig, insbesondere hoch leitfähig sind. Der erste metallische Stoff kann ein Reinstoff, ein Gemenge oder ein Gemisch, insbesondere homogenes Gemisch sein und/oder ein Edelmetall, ein Übergangsmetall, eine Metalllegierung und/oder Kupfer, vorzugsweise reines Kupfer, aufweisen und/oder sein. Außerdem kann der erste metallische Stoff halbleitend sein oder elektrisch nicht leitende Anteile aufweisen. Besonders bevorzugt ist der erste metallische Stoff Kupfer, Silber, Gold, Aluminium und/oder Titan oder eine Legierung mit mindestens einem dieser Stoffe. Der erste metallische Stoff kann auch ein fester Körper, beispielsweise eine Gegenelektrode, sein. Ferner kann der erste metallische Stoff zumindest ein Teil einer Elektrode, insbesondere einer Anode und/oder einer Gegenelektrode, sein. Alternative Ausgestaltung des ersten metallischen Stoffes sind auch denkbar. So kann der metallische Stoff pulverförmig und/oder krümelig sein. Der, insbesondere pulverförmige, erste metallische Stoff kann im und/oder mit dem zweiten Elektrolyten vermischt sein. Grundsätzlich kann der zweite Elektrolyt mit dem eingebrachten ersten metallischen Stoff ein heterogenes Gemisch sein.

In einer besonders bevorzugten Ausgestaltung ist der zweite Elektrolyt flüssig oder in Lösung. Der zweite Elektrolyt kann mit dem eingebrachten ersten metallischen Stoff eine Suspension oder Lösung bilden. Es ist also bevorzugt, dass der zweite Elektrolyt eine Flüssigkeit aufweist, die den ersten metallischen Stoff lösen kann und/oder in der der erste metallische Stoff suspendierbar ist.

Grundsätzlich kann unter einem, insbesondere flüssigen, Elektrolyten eine elektrisch leitende Lösung verstanden werden, die Ionen, insbesondere Kationen und Anionen, aufweist. Die Ionen können positiv oder negativ geladene Atome und/oder Moleküle sein. Sie können dadurch entstehen, dass Salze, Säuren oder Laugen in positiv und/oder negativ geladene Atome und/oder Moleküle aufgespalten werden. Die Kationen und/oder Anionen können die Ladungsträger des Elektrolyten sein.

Für den Primärgalvanikprozess kann wenigstens ein Teil der Polymerstruktur mit dem zweiten Elektrolyten in Kontakt gebracht werden. Bevorzugt wird die Polymerstruktur zumindest teilweise in den zweiten Elektrolyten eingetaucht. Bevorzugt wird die gesamte Polymerstruktur mit dem zweiten Elektrolyten in Kontakt gebracht.

Für den Primärgalvanikprozess ist es außerdem vorgesehen, dass über die Polymerstruktur ein zweiter Stromfluss durch den zweiten Elektrolyten erzeugt wird. Hierfür ist es bevorzugt, dass ein Stromfluss zwischen einer Kathode und einer Anode, insbesondere auch durch den zweiten Elektrolyten, stattfindet. Die Kathode und die Anode können dazu an eine Spannungsquelle angeschlossen sein. Bevorzugt fließt der zweite Stromfluss durch die Polymerstruktur. Auch deshalb kann es vorgesehen sein, dass die Polymerstruktur zumindest einen Teil der Oberfläche der Kathode ist. Insbesondere kann die Polymerstruktur die Oberfläche der Kathode bilden. Zwischen der Kathode und dem Elektrolyten fließt bevorzugt auch nur im Bereich der Polymerstruktur ein Strom für den Primärgalvanikprozess.

Die Anode kann eine beliebige aus dem Stand der Technik bekannte Anode für eine Galvanisierung sein. Dazu weist die Anode bevorzugt den ersten metallischen Stoff auf. Insbesondere kann die Anode von dem ersten metallischen Stoff im Wesentlich gebildet sein.

Es ist außerdem bevorzugt, dass auf den mit dem zweiten Elektrolyten in Kontakt gebrachten Bereich der Polymerstruktur ein leitfähiger Metallfilm der vorgegebenen Struktur gebildet und/oder abgeschieden wird. Es ist also bevorzugt, dass eine metallische Schicht, insbesondere aus dem ersten metallischen Stoff, galvanisch auf der Polymerstruktur abgeschieden wird. Durch Anlegen einer Spannung zwischen der Polymerstruktur und einer Gegenelektrode, insbesondere die von dem ersten metallischen Stoff gebildet wird oder diesen aufweist, kann ein Atom oder Molekül des ersten metallischen Stoffes zu einem positiv geladenen Metall-Ion (hier: Kation) oxidiert werden. Dieses Metall-Ion kann an der Polymerstruktur (hier: Kathode) zu Metall reduziert werden. Dadurch kann eine Abscheidung des ersten metallischen Stoffes an der Polymerstruktur erreicht werden. In Abhängigkeit der Spannungshöhe und/oder der Dauer des Anlegens der Spannung kann die Dicke der abzuscheidenden Metallschicht auf der. Polymerstruktur bestimmt und/oder gesteuert werden. Sofern nur ein Teil der Polymer-struktur mit dem zweiten Elektrolyten in Kontakt gebracht wird, findet eine galvanische Abscheidung auch nur in diesem Bereich statt.

An dieser Stelle sei noch einmal deutlich darauf hingewiesen, dass es bevorzugt ist, dass die galvanische Abscheidung des ersten metallischen Stoffes, vorzugsweise nur, im Bereich der Polymerstruktur und/oder auf der Polymerstruktur erfolgt. So ist es bevorzugt, dass auf der Oberfläche der (Struktur-)Elektrode und/oder Kathode, die nicht von der leitfähigen Polymerstruktur bedeckt und/oder gebildet werden, zumindest im Wesentlichen keine galvanische Abscheidung eines metallischen Stoffes erfolgt. Eine Elektrode, insbesondere eine Kathode, dessen Oberfläche zumindest teilweise durch die Polymerstruktur gebildet und/oder von der Polymerstruktur bedeckt ist, insbesondere in dem Bereich, der mit dem zweiten Elektrolyten in Kontakt gebracht wird, kann in dem zu der Polymerstruktur komplementären Bereich und/oder in dem übrigen Bereich der Oberfläche isolierend ausgestaltet sein und/oder einen isolierenden Stoff aufweisen und/oder von diesem bedeckt sein. Radial und/oder in der Dicke kann der isolierende Stoff in der Weise ausgestaltet sein, dass die Polymerstruktur und der isolierende Stoff eine im Wesentlichen glatte, ebene und/oder stetig verlaufende Oberfläche ist.

Wie bereits zuvor erwähnt, zeichnet sich das Verfahren zur Herstellung einer Leiterbahn auf einem Substrat auch durch ein zweites galvanisches Abscheiden eines zweiten metallischen Stoffes (zuvor bezeichnet als der Sekundärgalvanikprozess) auf zumindest einem Teil der ersten Metallstruktur aus, so dass eine zweite Metallstruktur (also die Kontaktmetallstruktur) entsteht.

Der Sekundärgalvanikprozess wird bevorzugt nach dem Primärgalvanikprozess ausgeführt. Grundsätzlich können jedoch zwischen dem Primärgalvanikprozess und dem Sekundärgalvanikprozess weitere, beliebige, Prozessschritte ausgeführt werden. Insbesondere kann der Primärgalvanikprozess auch mehrfach, insbesondere hintereinander, vor dem Sekundärgalvanikprozess ausgeführt werden. Grundsätzlich kann der Sekundärgalvanikprozess auch vor dem Primärgalvanikprozess ausgeführt werden.

In ihren Grundeigenschaften ähneln sich der Sekundärgalvanikprozess und der Primärgalvanikprozess. Beiden zugrunde liegt, dass Metall elektrochemisch abgeschieden wird.

Es kann bevorzugt sein, dass für den Sekundärgalvanikprozess wenigstens ein Teil der Metallstruktur in Kontakt mit dem, vorzugsweise flüssigen, dritten Elektrolyten gebracht wird. Hierbei kann in den dritten Elektrolyten ein zweiter metallischer Stoff eingebracht sein. Der dritte Elektrolyt kann also einen zweiten metallischen Stoff aufweisen. Als zweiter metallischer Stoff kommen insbesondere diejenigen Stoffe in Betracht, die elektrisch leitfähig, insbesondere hoch leitfähig, sind. Der zweite metallische Stoff kann ein Reinstoff, ein Gemenge oder ein Gemisch, insbesondere homogenes Gemisch, sein und/oder ein Lot, ein Edelmetall, ein Übergangsmetall, eine Metalllegierung, ein Nanometall und/oder Kupfer, oder Metallverbindungen, aufweisen oder sein. Außerdem kann der zweite metallische Stoff halbleitend sein und/oder elektrisch nicht leitende Anteile aufweisen. Besonders bevorzugt ist der zweite metallische Stoff Kupfer, Silber, Gold, Indium und/oder Titan oder eine Legierung mit mindestens einem dieser Stoffe. Der zweite metallische Stoff kann ein fester Körper, beispielsweise eine Gegenelektrode, sein. Ferner kann der zweite metallische Stoff zumindest ein Teil einer Elektrode, insbesondere einer Anode und/oder einer Gegenelektrode, sein. Alternative Ausgestaltungen des zweiten metallischen Stoffes sind auch denkbar. So kann der zweite metallische Stoff pulverförmig und/oder krümelig sein. Der, insbesondere pulverige, zweite metallische Stoff kann in und/oder mit dem dritten Elektrolyten vermischt sein und/oder mit diesem eine Suspension oder Lösung bilden. Grundsätzlich kann der dritte Elektrolyt mit dem eingebrachten zweiten metallischen Stoff ein heterogenes Gemisch sein.

Der erste und zweite metallische Stoff, der durch den Primärgalvanikprozess bzw. durch den Sekundärgalvanikprozess abgeschieden wird, kann sich in seinen Stoffeigenschaften unterscheiden. Grundsätzlich ist es jedoch möglich, dass die ersten und zweiten metallischen Stoffe sehr ähnliche Stoffe sind. Beispielsweise kann der erste metallische Stoff Silber und/oder der zweite metallische Stoff Nanosilber sein und/oder aufweisen. Besonders bevorzugt kann der zweite metallische Stoff auch andere nanometallische Stoffe, wie Nanogold, Nanoplatin und/oder Nanoindium, sein oder aufweisen.

In einer besonders bevorzugten Ausgestaltung ist der dritte Elektrolyt flüssig oder in Lösung. Der dritte Elektrolyt kann mit dem eingebrachten zweite metallischen Stoff eine Suspension oder Lösung bilden. Es ist also bevorzugt, dass der dritte Elektrolyt eine Flüssigkeit aufweist, die den zweiten metallischen Stoff lösen kann und/oder in der der zweite metallische Stoff suspendierbar ist.

Grundsätzlich kann unter einem, insbesondere flüssigen, Elektrolyten eine elektrisch leitende Lösung verstanden werden, die Ionen, insbesondere Kationen und Anionen, aufweist. Die Ionen können positiv oder negativ geladene Atome und/oder Moleküle sein. Sie können dadurch entstehen, dass Salze, Säuren oder Laugen in positiv oder negativ geladene Atome und/oder Moleküle aufgespalten werden. Die Kationen und/oder Anionen können die Ladungsträger des dritten Elektrolyten sein.

Für den Sekundärgalvanikprozess kann wenigstens ein Teil der Metallstruktur mit dem dritten Elektrolyten in Kontakt gebracht werden. Bevorzugt wird die Metallstruktur zumindest teilweise in den dritten Elektrolyten eingetaucht. Bevorzugt wird die gesamte Metallstruktur mit dem dritten Elektrolyten in Kontakt gebracht.

Für den Sekundärgalvanikprozess kann es vorgesehen sein, dass über die Metallstruktur ein dritter Stromfluss durch den dritten Elektrolyten erzeugt wird. Hierfür ist es bevorzugt, dass ein Stromfluss zwischen einer Kathode und einer Anode, insbesondere auch durch den dritten Elektrolyten, stattfindet. Die Kathode und die Anode können dazu an eine Spannungsquelle angeschlossen sein. Bevorzugt fließt der dritte Stromfluss durch die Metallstruktur. Auch deshalb kann es vorgesehen sein, dass die Metallstruktur zumindest einen Teil der Oberfläche der Kathode ist. Insbesondere kann die Metallstruktur die Oberfläche der Kathode bilden. Zwischen der Kathode und dem dritten Elektrolyten fließt bevorzugt auch nur im Bereich der Metallstruktur ein Strom für den Sekundärgalvanikprazess.

Die Anode kann eine beliebige aus dem Stand der Technik bekannte Anode für eine Galvanisierung sein. Dazu weist die Anode bevorzugt den zweiten metallischen Stoff auf. Insbesondere kann die Anode von dem zweiten metallischen Stoff im Wesentlich gebildet sein.

Es ist außerdem bevorzugt, dass auf den mit dem dritten Elektrolyten in Kontakt gebrachten Bereich der Metallstruktur ein, insbesondere weiterer, leitfähiger Metallfilm der vorgegebenen Struktur gebildet und/oder abgeschieden wird. Es ist also bevorzugt, dass eine metallische Schicht, insbesondere aus dem zweiten metallischen Stoff, galvanisch auf der Metallstruktur abgeschieden wird. Durch Anlegen einer Spannung zwischen der Metallstruktur und einer Gegenelektrode, insbesondere die von dem zweiten metallischen Stoff gebildet wird oder diesen aufweist, kann ein Atom oder Molekül des zweiten metallischen Stoffes zu einem positiv geladenen Metall-Ion (hier: Kation) oxidiert werden. Dieses Metall-Ion kann an der Metallstruktur (hier: Kathode) zu Metall reduziert werden. Dadurch kann eine Abscheidung des zweiten metallischen Stoffes an der Metallstruktur erreicht werden. In Abhängigkeit der Spannungshöhe und/oder der Dauer des Anlegens der Spannung kann die Dicke der abzuscheidenden Metallschicht auf der Metallstruktur bestimmt und/oder gesteuert werden. Sofern nur ein Teil der Metallstruktur mit dem dritten Elektrolyten in Kontakt gebracht wird, findet eine galvanische Abscheidung auch nur in diesem Bereich statt.

An dieser Stelle sei noch einmal deutlich darauf hingewiesen, dass es bevorzugt ist, dass die galvanische Abscheidung des zweiten metallischen Stoffes, vorzugsweise nur, im Bereich der Metallstruktur und/oder auf der Metallstruktur erfolgt. So ist es bevorzugt, dass auf der Oberfläche der (Struktur-)Elektrode und/oder Kathode, die nicht von der leitfähigen Polymerstruktur und/oder Metallstruktur bedeckt und/oder gebildet werden, zumindest im Wesentlichen keine galvanische Abscheidung eines zweiten metallischen Stoffes erfolgt.

Grundsätzlich ist es bevorzugt, dass der Primärgalvanikprozess mit dem ersten metallischen Stoff und vor dem Sekundärgalvanikprozess ausgeführt wird. Für bevorzugte Anwendungen kann es sinnvoll sein, dass die Kontaktmetallstruktur nicht auf der Metallstruktur abgeschieden wird, sondern dass die Metallstruktur auf der Kontaktmetallstruktur abgeschieden wird. So kann es beispielsweise sinnvoll sein, dass die Kontaktmetallstruktur auf der Polymerstruktur abgeschieden wird. Danach kann auf der Kontaktmetallstruktur die Metallstruktur abgeschieden werden. Alle drei Strukturen können danach auf ein Transfersubstrat transferiert und/oder übertragen werden. Daraufhin kann die Polymerstruktur entfernt werden. Somit kann die Kontaktmetallstruktur eine Oberfläche der drei zusammenhängenden Strukturen sein. Beispielhaft konnte somit erläutert werden, dass ein Abscheiden der Kontaktmetallstruktur vor einem Abscheiden der Metallstruktur sinnvoll sein kann. Denn durch den Transfer der Strukturen auf ein Transfersubstrat wird die Reihenfolge der Strukturen umgekehrt bzw. umgedreht.

Eine bevorzugte Ausgestaltung des Verfahrens zeichnet sich dadurch aus, dass der Primärgalvanikprozess mit dem zweiten, insbesondere anstatt mit dem ersten, metallischen Stoff ausgeführt wird. Hierbei kann durch den Primärgalvanikprozess die Kontaktmetallstruktur auf der Polymerstruktur entstehen. Außerdem kann es bevorzugt sein, dass der Sekundärgalvanikprozess mit dem ersten, anstatt mit dem zweiten, metallischen Stoff ausgeführt wird. Hierbei kann durch den Sekundärgalvanikprozess die Metallstruktur auf der Kontaktmetallstruktur entstehen. Mit anderen Worten zeichnet sich eine bevorzugte Ausgestaltung des Verfahrens dadurch aus, dass ein erstes galvanisches Abscheiden des zweiten metallischen Stoffes auf zumindest einem Teil der Polymerstruktur erfolgen kann, insbesondere so dass die Kontaktmetallstruktur entsteht. Das Verfahren kann sich bevorzugt dadurch auszeichnen, dass durch ein zweites galvanisches Abscheiden des ersten metallischen Stoffes auf zumindest einem Teil der Kontaktmetallstruktur die Metallstruktur entstehen kann.

Eine bevorzugte Ausgestaltung des Verfahrens zeichnet sich dadurch aus, dass beim Primärgalvanikprozess wenigstens ein Teil der Polymerstruktur in Kontakt mit dem, vorzugsweise flüssigen, zweiten Elektrolyten gebracht werden. In den zweiten Elektrolyten kann der zweite metallische Stoff, insbesondere ein Übergangsmetall und/oder ein Edelmetall, vorzugsweise Silber und/oder Indium, eingebracht sein. Außerdem kann sich der Primärgalvanikprozess hierbei dadurch auszeichnen, dass über die Polymerstruktur ein zweiter Strom durch den zweiten Elektrolyten erzeugt wird. Hierbei kann auf den mit dem zweiten Elektrolyten in Kontakt gebrachten Bereich der Polymerstruktur ein leitfähiger Metallfilm der vorgegebenen Struktur, nämlich die Kontaktmetallstruktur, gebildet und/oder abgeschieden werden. Es kann also für den Primärgalvanikprozess der zweite metallische Stoff verwendet werden, sodass mit dem Primärgalvanikprozess auch die Kontaktmetallstruktur abscheidbar ist. Eine weitere vorteilhafte Ausgestaltung des Verfahrens zeichnet sich dadurch aus, dass beim Sekundärgalvanikprozess wenigstens ein Teil der Kontaktmetallstruktur in Kontakt mit einem, vorzugsweise flüssigen, dritten Elektrolyten gebracht wird. Hierbei kann in den dritten Elektrolyten der erste metallische Stoff, insbesondere ein Übergangsmetall, vorzugsweise Kupfer, eingebracht sein. Weiter kann sich der Sekundärgalvanikprozess dadurch vorteilhaft auszeichnen, dass über die Kontaktmetallstruktur, und insbesondere auch über die Polymerstruktur, ein dritter Strom durch den Elektrolyten erzeugt werden kann. Hierbei kann auf den mit dem dritten Elektrolyten in Kontakt gebrachten Bereich der Kontaktmetallstruktur ein, insbesondere weiterer, leitfähiger Metallfilm der vorgegebenen Struktur, nämlich die Metallstruktur, gebildet und/oder abgeschieden werden. Weiterhin ist das Verfahren durch ein thermisches Verbinden der ersten und/oder der zweiten Metallstruktur mit dem Substrat gekennzeichnet (Verbindungsprozess), wobei die mit dem Substrat verbundene Metallstruktur das, insbesondere schmelzbare, Verbindungsmittel ist. Unter einem thermischen Verbinden kann ein thermisches Verfahren, insbesondere unter Zugabe von Energie und Wärme, zum, insbesondere stoffflüssigen, Verbinden und/oder Fügen von Stoffen, insbesondere Werkstoffen, und/oder anderen Elementen verstanden werden. Auch kann das Verbinden ein Verbinden durch Löten, Schweißen, Laminieren und/oder Ultraschalleinwirkung sein. Bei dem thermischen Verfahren kann die Kontaktmetallstruktur und/oder die Metallstruktur durch Energiezufuhr und/oder durch Wärmezufuhr zumindest an einer Grenzfläche zu einem der zu verbindenden Stoffe schmelzen und/oder in einen flüssigen Zustand überführt werden. Insbesondere kann die Kontaktmetallstruktur und/oder die Metallstruktur wie ein Lot wirken und/oder ein Lot sein. In einem flüssigen und/oder breiigen Zustand kann die Kontaktmetallstruktur und/oder die Metallstruktur mit den zu verbindenden Stoffen kontaktiert werden. Die Kontaktmetallstruktur und/oder die Metallstruktur kann sich durch das Kontaktieren und/oder durch eine Energiezufuhr in deren Form, Geometrie und/oder Struktur verändern. Nach dem Kontaktieren kann der Kontaktmetallstruktur und/oder die Metallstruktur Energie und/oder Wärme entzogen werden. Insbesondere kann der Kontaktmetallstruktur und/oder der Metallstruktur die Menge an Energie und/oder Wärme entzogen werden, dass die Kontaktmetallstruktur und/oder die Metallstruktur erstarrt. Auf diese Weise können zwei Stoffe und/oder Elemente, insbesondere die Metallstruktur und das Substrat und/oder die Kontaktmetallstruktur und das Substrat, miteinander verbunden werden. Diese können insbesondere auch zusammengefügt sein. Mit anderen Worten kann die Kontaktmetallstruktur und/oder die Metallstruktur als Mittel zum Verbinden der Metallstruktur und des Substrats wirken.

Eine besonders bevorzugte Ausgestaltung des Verfahrens zeichnet sich dadurch aus, dass der Kontaktmetallstruktur und/oder die Metallstruktur für den Verbindungsprozess Energie, insbesondere Wärme, zugeführt wird, sodass die Kontaktmetallstruktur und/oder die Metallstruktur zumindest an der Grenzfläche schmilzt, die zu dem Substrat ausgerichtet ist und/oder ausgerichtet werden soll. Es kann bevorzugt sein, dass die Kontaktmetallstruktur, insbesondere durch Energie und/oder Wärmezufuhr, auf eine Temperatur erwärmt wird, die oberhalb der Schmelztemperatur des zweiten metallischen Stoffes ist und/oder die unterhalb der Schmelztemperatur des ersten metallischen Stoffes, des Substrates und/oder des Polymers bzw. der Polymerstruktur ist.

Eine weitere bevorzugte Ausgestaltung des Verfahrens zeichnet sich dadurch aus, dass die Kontaktmetallstruktur und/oder die Metallstruktur für den Verbindungsprozess vor, während oder nach dem Schmelzen der Kontaktmetallstruktur und/oder die Metallstruktur mit dem Substrat in Kontakt gebracht wird. Mit anderen Worten kann es bevorzugt sein, dass die Metallstruktur und/oder die Kontaktmetallstruktur mit dem Substrat kontaktiert wird, und zwar insbesondere vor, während und/oder nach der Erwärmung der Kontaktmetallstruktur und/oder die Metallstruktur. Ferner ist es von Vorteil, wenn hierbei die Metallstruktur zu dem Substrat in der Weise, insbesondere relativ, positioniert wird, dass die, insbesondere flüssige, Kontaktmetallstruktur wenigstens eine Kontaktverbindung zwischen der Metallstruktur und dem Substrat bilden kann. Es ist also möglich, dass die Kontaktmetallstruktur schmilzt, bevor diese mit dem Substrat kontaktiert wird. Es ist auch möglich, dass die Kontaktmetallstruktur und/oder die Metallstruktur mit dem Substrat kontaktiert wird, beispielsweise durch eine im Wesentlichen kraftlose Berührung, und danach die Energie und/oder Wärme zugeführt wird, sodass die Kontaktmetallstruktur und/oder die Metallstruktur zumindest an der dem Substrat zugewandten Seite schmilzt. Ferner ist es möglich, dass der Kontaktmetallstruktur Energie und/oder Wärme zugeführt wird, während diese auf das Substrat zu bewegt wird. Insbesondere solang die Kontaktmetallstruktur und/oder die Metallstruktur flüssig ist, kann es bevorzugt sein, die Metallstruktur, die Kontaktmetallstruktur und/oder das Substrat zueinander auszurichten. Hierbei können diese relativ zueinander positioniert werden. Dies bietet den besonderen Vorteil, dass die Leiterbahn sehr exakt, und zwar insbesondere im Sinne der räumlichen und/oder relativen Positionierung zueinander, auf das Substrat aufgebracht und/oder mit diesem verbunden werden kann. Somit ist es möglich, Leiterbahnen auch auf sehr komplexen Substraten aufzubringen, die bezüglich ihrer Kontaktstellen zu einer Leiterbahn eine sehr genaue Positionierung der Leiterbahn voraussetzen.

Eine vorteilhafte Ausgestaltung des Verfahrens zeichnet sich dadurch aus, dass eine Solidustemperatur der Metallstruktur, des Substrates und/oder der Polymerstruktur größer, insbesondere deutlich größer, als die Solidustemperatur oder eine Liquidustemperatur der Kontaktmetallstruktur, ist. Eine Solidustemperatur kann die Temperatur eines Stoffes, insbesondere einer Legierung, kennzeichnen, bei der und/oder unterhalb der der Stoff, insbesondere vollständig, in fester Phase vorliegt. Unterhalb der Solidustemperatur kann der Stoff, insbesondere die Legierung, fest, insbesondere vollständig fest, bis zur Liquidustemperatur breiig, darüber insbesondere vollständig flüssig sein. Die Kontaktmetallstruktur kann also auf eine Temperatur erwärmt werden, bei der die Kontaktmetallstruktur schmilzt. Hierbei können die Metallstruktur, die Polymerstruktur und/oder das Substrat auf die gleiche Temperatur erwärmt sein, ohne dass diese schmelzen und/oder breiig werden. Diese Stoffeigenschaften können vorteilhaft dazu ausgenutzt werden, dass das Substrat und die Metallstruktur bei einer Temperatur zueinander positioniert werden, bei der die Kontaktmetallstruktur flüssig und/oder breiig ist. Denn die Metallstruktur und das Substrat können bei dieser Temperatur fest sein. Sie können deshalb mit einer sehr geringen Fehlertoleranz zueinander positionierbar sein.

Eine weitere bevorzugte Ausgestaltung des Verfahrens zeichnet sich dadurch aus, dass der Kontaktmetallstruktur bei dem Verbindungsprozess nach dem Kontaktieren Energie, insbesondere Wärme, entzogen wird, sodass die Kontaktmetallstruktur erstarrt. Es kann bevorzugt sein, dass die Kontaktmetallstruktur auf eine Temperatur abgekühlt wird, die unterhalb der Solidustemperatur des zweiten metallischen Stoffes ist, vorzugsweise so, dass die Kontaktmetallstruktur als Haft- und/oder Kontaktmittel zwischen der Metallstruktur und dem Substrat wirkt. Durch den ersten Primärgalvanikprozess oder Sekundärgalvanikprozess können die Metallstruktur und die Kontaktmetallstruktur haftend miteinander verbunden sein. Eine Haftwirkung zwischen der Kontaktmetallstruktur und dem Substrat kann durch das zuvor erläuterte thermische Verbinden und/oder Fügen entstehen. Dieses Fügen und/oder Verbinden kann stoff-, kraft- und/oder formschlüssig sein. Insbesondere kann an der Grenzfläche zwischen der Kontaktmetallstruktur und dem Substrat eine Verbindung durch Diffusion entstehen. Sofern das Substrat zumindest bereichsweise eine Oberflächenrauheit aufweist, kann das Kontaktmetallsubstrat in dessen flüssiger und/oder breiiger Phase in die Oberflächenvertiefungen des Substrates eindringen und nach einem Abkühlen der Kontaktmetallstruktur eine stoff-, form- und/oder kraftschlüssige Verbindung zwischen dem Substrat und der Kontaktmetallstruktur und insbesondere auch zwischen dem Substrat und der Metallstruktur herstellen.

Grundsätzlich ist es bevorzugt, dass der erste metallische Stoff und der zweite metallische Stoff unterschiedliche Stoffe sind. Insbesondere sofern diese Legierungen und/oder Stoffgemische sind, können der erste metallische Stoff und der zweite metallische Stoff gleiche und/oder gleichartige Stoffanteile aufweisen. Insbesondere deshalb können sie auch ähnliche thermische Schmelzeigenschaften aufweisen. Dazu kann auch die Schmelztemperatur zählen. Es ist also möglich, dass der erste metallische Stoff und der zweite metallische Stoff bei der zumindest im Wesentlichen gleichen Temperatur schmelzen. Außerdem können jeweils die Solidustemperaturen und/oder jeweils die Liquidustemperaturen der beiden Stoffe sich durch eine ausreichend hohe Temperaturdifferenz unterscheiden. Eine solche Temperaturdifferenz kann zwischen 0,1 Kelvin und 1000 Kelvin, insbesondere zwischen 100 und 1000 Kelvin, bevorzugt zwischen 200 und 500 Kelvin sein. Es ist ein angestrebter Vorteil der Erfindung, dass die Leiterbahn beim Kontaktieren mit dem Substrat im Wesentlichen nicht schmilzt und/oder thermisch verformt wird. Insbesondere wird es angestrebt, dass trotz vergleichbarer Stoffeigenschaften der Metallstruktur und Kontaktmetallstruktur die Kontaktmetallstruktur schmelzbar ist und/oder zum schmelzen gebracht werden kann, wobei die Metallstruktur zumindest im Wesentlichen nicht schmilzt und/oder sich thermisch nicht verformt.

Eine bevorzugte Ausgestaltung des Verfahrens zeichnet sich dadurch aus, dass ein Oberfläche-zu-Volumen-Verhältnis (AV-Verhältnis) von der Kontaktmetallstruktur größer ist, insbesondere deutlich größer ist, als das AV-Verhältnis der Metallstruktur. Das AV-Verhältnis kann der Quotient von der Oberfläche, vorzugsweise Mantelfläche, insbesondere ohne die Deckflächen, zu dem Volumen eines geometrischen Körpers sein. Mit anderen Worten ist es von Vorteil, wenn die Kontaktmetallstruktur bei gleichem Volumen eine größere Oberfläche aufweist als die Metallstruktur. Denn hierdurch bzw. durch das größere AV-Verhältnis kann die Kontaktmetallstruktur eine größere, insbesondere relative, Grenzfläche für einen Energietransport aufweisen. Eine Energie-und/oder Wärmestrahlung, die auf die Kontaktmetallstruktur gerichtet sein kann, strahlt, wenn auch mit einer geringeren Intensität, zumeist auch auf die Metallstruktur, insbesondere in deren Grenzbereich zu der Kontaktmetallstruktur. Weist die Kontaktmetallstruktur nun aber ein größeres AV-Verhältnis auf, kann mehr Energie pro Zeit an die Kontaktmetallstruktur übertragen werden als an die Metallstruktur. Folglich kann, insbesondere sogar bei gleichwertiger Energie und/oder Wärmeeinstrahlung, die Temperatur der Kontaktmetallstruktur schneller steigen als die Temperatur der Metallstruktur (Hierbei wird implizit vorausgesetzt, dass die Kontaktmetallstruktur und die Metallstruktur eine für diesen theoretischen Vergleich gleiche Masse und Anfangstemperatur aufweisen. Diese Voraussetzungen sind hier exemplarisch genannt und sollen keine Einschränkung darstellen.)

Eine weiter bevorzugt Ausgestaltung des Verfahrens zeichnet sich dadurch aus, dass die Kontaktmetallstruktur im Wesentlichen aus kleinen Nanopartikeln besteht und/oder diese aufweist. Nanopartikel können an der Oberfläche der Kontaktmetallstruktur angeordnet sein oder die bilden. Somit kann die Oberfläche die Metallstruktur eine Fläche aufweisen, die nahezu oder im Wesentlichen die Summe der Oberflächen der Nanopartikel entspricht, die an der Oberfläche der Kontaktmetallstruktur angeordnet sind und/oder diese bilden. Auch kann die Oberfläche der Metallkontaktstruktur gegenüber dem Volumen der Metallkontaktstruktur sehr groß sein.

Außerdem wurde festgestellt, dass die Reduzierung der Korngröße eines Stoffes zu einer Reduzierung der Solidustemperatur, der Liquidustemperatur und/oder der allgemeinen Schmelztemperatur führen kann. Diese Erkenntnis kann dazu ausgenutzt werden, dass die Kontaktmetallstruktur schneller als die Metallstruktur schmilzt, wobei deren Stoffeigenschaften, zumindest in ihrer Strukturformel, ähnlich und/oder gleich sind. Eine weitere bevorzugte Ausgestaltung des Verfahrens zeichnet sich dadurch aus, dass der zweite metallische Stoff porös ist und/oder eine insbesondere deutlich kleinere Korngröße als der erste metallische Stoff aufweist. Es ist besonders bevorzugt, dass der zweite metallische Stoff Partikel mit einem mittleren Durchmesser von höchstens 50 nm aufweist. Grundsätzlich ist es bevorzugt, dass der zweite metallische Stoff Partikel mit einem mittleren Durchmesser und/oder einer Korngröße von höchstens 800 Nanometer, insbesondere von höchstens 700, 600, 500, 400, 300, 200, 100, 90, 80, 70, 60, 50, 40, 30, 20 oder 10 Nanometer, aufweist und/oder ein nanometallischer Stoff ist. Eine in diesem Sinne beispielhafte Ausgestaltung zeichnet sich dadurch aus, dass der erste metallische Stoff Silber ist und dass der zweite metallische Stoff Silber mit einer Korngröße ist, die deutlich kleiner als die Korngröße des ersten Stoffes ist und/oder dass der zweite metallische Stoff Nanosilber ist. Bei dieser Ausgestaltung ist es möglich, dass der zweite metallische Stoff, also bevorzugt Silber mit einer kleinen Korngröße und/oder Nanosilber, eine sehr geringe Schmelztemperatur, beispielsweise eine Schmelztemperatur zwischen 350 und 550 °C, aufweist, wohin der erste metallische Stoff bzw. das Silber eine Schmelztemperatur zwischen 900 und 1100°C aufweist. Eine Energie und/oder Wärmezufuhr zu der Kontaktmetallstruktur kann in der Weise gesteuert sein, dass ausreichend Energie und/oder Wärme an die Kontaktmetallstruktur übertragen wird, sodass die Kontaktmetallstruktur, zumindest an der Grenzfläche zu dem Substrat und/oder an der zu dem Substrat auszurichtenden Grenzfläche, schmilzt und/oder breiig wird, wobei die Energie und/oder Wärmezufuhr unterbrochen wird, bevor die Metallstruktur schmilzt und/oder breiig wird. Dies ist insbesondere deshalb möglich, weil der zweite metallische Stoff eine geringere Korngröße als der erste metallische Stoff aufweist und/oder dass der zweite metallische Stoff ein nanometallischer Stoff ist. Es kann ferner dadurch verursacht sein, dass die Kontaktmetallstruktur ein größeres AV-Verhältnis aufweist als die Metallstruktur. Beide Effekte können auch kombiniert sein. Bei der Sekundärgalvanisierung und/oder allgemein bei der Galvanisierung mit dem zweiten metallischen Stoff ist darauf zu achten, dass die Korngrößen des zweiten metallischen Stoffes zumindest im Wesentlichen nicht stark verändert werden.

Eine bevorzugte Ausgestaltung des Verfahrens zeichnet sich dadurch aus, dass das Substrat einen elektrisch halbleitenden Stoff und/oder eine Halbleiterstruktur aufweist und/oder ein Halbleitermaterial, insbesondere ein p-dotiertes oder n-dotiertes Halbleitermaterial, ist. Besonders bevorzugt ist das Substrat ein Substrat und/oder Funktionssubstrat einer Solarzelle. Außerdem ist es besonders bevorzugt, dass das Substrat die Frontseite und/oder die Rückseite einer Solarzelle bildet. Grundsätzlich besteht an der Grenzfläche zwischen einem Halbleiter und einem Metall die Möglichkeit, dass sich ein Schottky-Übergang bildet. Für praktische Anwendung wird dieser Übergang jedoch nicht angestrebt.

Vielmehr ist dieser oftmals unerwünscht. Es ist deshalb ein angestrebter Vorteil der Erfindung, dass zwischen der Leiterbahn und dem Substrat kein Schottky-Übergang und/oder zumindest im Wesentlichen kein Schottky-Übergang gebildet wird. Eine bevorzugte Ausgestaltung des Verfahrens zeichnet sich dadurch aus, dass der zweite metallische Stoff in der Weise gewählt ist, dass sich ein ohm'scher Kontakt zur Halbleiteroberfläche ausbildet.

Der Wirkungsgrad η einer Solarzelle (Solarzellenwirkungsgrad) kann durch den Quotienten einer maximalen Abgabeleistung $P_{max}$ zu einer einfallenden Lichtleistung $P_l$ bestimmbar sein:

$$\eta = \frac{P_{\text{max}}}{P_L} \quad .$$

Neben der Wahl des Bandabstandes und/oder des Halbleitermaterials kann der Solarzellenwirkungsgrad auch durch eine Verringerung des Bahnwiderstandes und/oder durch eine Verringerung der Abschattung durch einen Frontseiten- und/oder Rückseitenkontakt beeinflussbar sein. Eine bevorzugte Ausgestaltung des Verfahrens zeichnet sich dadurch aus, dass der erste metallische Stoff und/oder der zweite metallische Stoff eine hohe, insbesondere eine sehr hohe, Leitfähigkeit aufweisen. Ferner ist es bevorzugt, dass die Leiterbahn, insbesondere ein "Fingerkontakt" einer Solarzelle, eine Breite von 1 Nanometer bis 10000 Mikrometer, insbesondere von 100 Nanometer bis 1000 Mikrometer, vorzugsweise von 5 Mikrometer bis 200 Mikrometer hat. Besonders bevorzugt ist, dass eine Leiterbahn eine Breite von 5 bis 200 $\mu$m aufweist. Außerdem zeichnet sich eine bevorzugte Ausgestaltung des Verfahrens dadurch aus, dass eine Leiterbahn, insbesondere ein "Fingerkontakt" einer Solarzelle, eine Dicke von 1 Nanometer bis 1000 Mikrometer, insbesondere von 100 Nanometer bis 100 Mikrometer, vorzugsweise von 5 Mikrometer bis 200 Mikrometer, hat. Besonders bevorzugt weist eine Leiterbahn eine Dicke von 5 bis 200 $\mu$m auf. Durch die geringe Dicke und/oder Breite einer Leiterbahn kann es gewährleistet sein, dass die Abschattung, insbesondere durch einen Frontseitenkontakt, auf einer Solarzelle möglichst gering ist. Grundsätzlich ist es auch möglich, dass eine Solarzelle gar keine Frontseitenkontaktleiterbahnen aufweist, sondern diese auf die Rückseite verlegt werden. In diesem Fall ist es jedoch auch vorteilhaft, dass die Leiterbahnen eine geringe dicke und/oder Breite aufweisen. Denn so können die Solarzellen möglichst kompakt ausgestaltet sein.

Ferner ist es angestrebt, dass eine Herstellung einer Leiterbahn auf einem Substrat möglichst kostengünstig ist. Da die Kontaktmetallstruktur sich bevorzugt durch ihre geringe Schmelztemperatur auszeichnet, kann sie relativ auf die Masse bezogen teurer sein als die Metallstruktur. Es ist deshalb bevorzugt, dass die Kontaktmetallstruktur möglichst dünn ist. Es ist bevorzugt, dass die für eine weitere Kontaktierung vorgesehene Metallstruktur eine Dicke von 100 nm bis 5 $\mu$m aufweist. Eine bevorzugte Ausgestaltung des Verfahrens zeichnet sich dadurch aus, dass die Kontaktmetallstruktur eine Dicke von 1 Nanometer bis 500 Mikrometer, insbesondere von 10 Nanometer bis 1 Mikrometer, vorzugsweise von 50 Nanometer bis 5 Mikrometer hat.

Viele aus dem Stand der Technik bekannten Verfahren zur Herstellung von Leiterbahnen auf Substraten sind nur beschränkt an die unterschiedlichen Rahmenbedingungen bezogen auf die Leiterbahn für ein bestimmtes Substrat, anpassbar. Dies soll an einem Beispiel erläutert werden. Soll beispielsweise der Querschnitt einer Leiterbahn verdoppelt werden, damit ein doppelt so hoher Strom durch die Leiterbahn fließen kann. Bei vielen Verfahren aus dem Stand der Technik ist es dazu notwenig, dass die dafür notwendigen Vorrichtungen mechanisch daran angepasst werden müssen und/oder neu hergestellt werden müssen. Es wird deshalb bevorzugt mit der Erfindung angestrebt, ein Verfahren bereitzustellen, mit dem Leiterbahnen mit verschiedenen Querschnitten herstellbar sind, ohne dass die für das Verfahren notwendigen Vorrichtungen daran jeweils angepasst sein müssen. Eine vorteilhafte Ausgestaltung zeichnet sich deshalb dadurch aus, dass eine Anordnung wenigstens zweier Leiterbahnen und/oder die Querschnittsfläche der ersten metallischen Schicht und/oder der Leiterbahn unter Zugrundelegung eines maximal für eine geplante Anwendung des Substrats mit Leiterbahn zulässigen elektrischen Widerstands der ersten metallischen Schicht und/oder der Leiterbahn festgelegt wird. Auch kann es bevorzugt sein, dass die Dauer der Primärgalvanisierung und/oder des zweiten Stroms der Primärgalvanisierung in der Weise, vorzugsweise unter Berücksichtung des zu erwartenden Stroms durch die Leiterbahn und/oder durch deren erste metallische Schicht, gesteuert wird, dass die erste metallische Schicht und/oder die Leiterbahn eine Querschnittsfläche aufweist, die an den zu erwartenden Strom angepasst ist, insbesondere wobei die Querschnittsfläche senkrecht und/oder normal zu der zu erwartenden Stromrichtung ist. Außerdem kann es bevorzugt sein, dass mehrere Leiterbahnen in der Weise, vorzugsweise unter Berücksichtigung des zu erwartenden Stroms durch die Leiterbahn, durch deren erste metallische Schicht und/oder durch das Substrat, räumlich voneinander hergestellt werden, dass jeweils die Querschnittsfläche einer ersten metallischen Schicht und/oder einer Leiterbahn an den zu erwartenden Strom, insbesondere an den zu erwartenden Strom einer jeweiligen Leiterbahn, angepasst ist. Diese Anpassung kann beispielsweise an die Ohmsche Verlustleistung einer Leiterbahn gekoppelt sein. Die Leiterbahn kann eine Leiterbahn einer Solarzelle und/oder eines Photovoltaikelements sein. Besonders für solche Anwendungen aus dem Bereich der "Energieerzeugung" ist es von Vorteil, wenn die Verlustleistung möglichst klein ist. Eine Verlustleistung $P_V$ kann allgemein bestimmt werden durch:

$$P_V = R * I^2$$

Hierbei ist $P_V$ die Verlustleistung, R der Ohmsche Widerstand einer Leiterbahn und I der zu erwartende Strom durch die Leiterbahn. Der Ohmsche Widerstand R kann in einer ersten Näherung durch den folgenden Zusammenhang bestimmt sein:

$$R = \rho * \frac{l}{A}$$

Hierbei ist ρ der spezifische Widerstand des ersten metallischen Stoffes, des zweiten metallischen Stoffes und/oder dem gemittelten spezifischen Widerstandes des ersten und zweiten metallischen Stoffes, I die Länge der Leiterbahn und A der Querschnitt der Leiterbahn. Durch die jeweilige Dauer und/oder durch den jeweiligen Strom bei dem Primärgalvanikprozess und/oder dem Sekundärgalvanikprozess kann die Dicke und/oder die Breite einer Leiterbahn steuerbar sein. Die beiden Parameter haben direkten Einfluss auf den Querschnitt A einer Leiterbahn. Durch die beiden zuvor erläuterten mathematischen Zusammenhänge kann durch die jeweilige Dauer und/oder durch den jeweiligen Strom des Primärgalvanikprozesses und/oder des Sekundärgalvanikprozesses der Widerstand einer Leiterbahn steuerbar und/oder bestimmbar sein. Wird es beispielsweise angestrebt, dass durch eine Leiterbahn ein doppelt so hoher Strom fließen soll, wobei es angestrebt ist, dass die Verlustleistung der Leiterbahn sich nicht verändern soll, so ist es notwendig, dass der Widerstand der Leiterbahn auf ein Viertel reduziert wird. Da der Widerstand der Leiterbahn durch das Verfahren bevorzugt steuerbar und/oder bestimmbar ist, kann dieses angestrebte Ziel erreichbar sein. Ferner kann die Struktur des Elektrodenkontaktbereiches, der Polymerstruktur, der Metallstruktur und/oder der Kontaktmetallstruktur vorgebbar sein. Somit können mehrere Leiterbahnen parallel oder in einer anderen Weise zueinander angeordnet sein und/oder miteinander verbunden sein. Somit kann ein Strom durch mehrere Leiterbahnen fließen und/oder auf mehrere Leiterbahnen aufgeteilt werden. Insbesondere durch eine Parallelschaltung von mehreren Leiterbahnen ist es möglich, die Verlustleistung an einen zu erwartenden Strom anzupassen.

Eine bevorzugte Ausgestaltung des Verfahrens zeichnet sich dadurch aus, dass der Primärgalvanikprozess auf der polymerbeschichteten Strukturelektrode stattfindet. Es kann also bevorzugt sein, dass die Polymerstruktur nach dem Polymerisationsprozess und vor dem Primärgalvanikprozess nicht von der Strukturelektrode entfernt wird. Außerdem kann es bevorzugt sein, dass die Polymerstruktur nach dem Polymerisationsprozess und nach dem Primärgalvanikprozess sowie vor dem Sekundärgalvanikprozess nicht von der Strukturelektrode entfernt wird. Die Polymerstruktur kann mit der Strukturelektrode, insbesondere elektrisch, kontaktiert sein. Insbesondere kann die Polymerstruktur rückseitig, insbesondere durch den Elektrodenkontaktbereich, kontaktiert sein. Es ist also möglich, dass die Strukturelektrode für den Polymerisationsprozess zumindest teilweise in Kontakt mit dem ersten elektrischen Elektrolyt gebracht wird. Hierbei kann sich die Polymerstruktur auf der Strukturelektrode bilden bzw. abscheiden. Danach kann die Strukturelektrode aus dem ersten Elektrolyt herausgenommen werden. Gegebenenfalls kann eine Säuberung der Oberfläche stattfinden. Dies kann insbesondere ein Abspülen der Oberfläche mit einer Flüssigkeit sein. Die Strukturelektrode mit der an ihr haftenden Polymerstruktur kann danach zumindest teilweise in Kontakt mit dem zweiten Elektrolyten gebracht werden. Durch den Primärgalvanikprozess kann eine Abscheidung des ersten metallischen Stoffes auf der Polymerstruktur erfolgen. Der, insbesondere zweite, Strom kann hierbei durch die Strukturelektrode, insbesondere durch den Elektrodenkontaktbereich der Strukturelektrode, und durch die Polymerstruktur, die rückseitig vorzugsweise nur mit dem Elektrodenkontaktbereich der Strukturelektrode, insbesondere elektrisch leitend, kontaktiert ist, fließen, so dass im Wesentlichen nur an der Polymerstruktur eine Metallabscheidung erfolgt. Bei dem Primärgalvanikprozess und/oder bei dem Polymerisationsprozess kann die Schichtdicke der Metallstruktur bzw. der Polymerstruktur durch die Stromstärke und/oder durch die Höhe der Spannung bestimmt und/oder gesteuert werden.

Das erfindungsgemäße Verfahren ist auch dann besonders vorteilhaft, wenn das Verfahrensprodukt, nämlich die mindestens eine Leiterbahn auf dem Substrat, möglichst kostengünstig und/oder möglichst schnell hergestellt werden kann. Ein besonders bevorzugtes Verfahren kann sich dadurch auszeichnen, dass die kostenintensiven Bauteile wiederverwendbar sind und/oder nicht in mehreren Verfahrensschritten "blokkiert" werden (sondern vorzugsweise nach einem der Verfahrensschritte wieder "freigegeben" werden).

In einer vorteilhaften Ausgestaltung ist die Strukturelektrode wieder verwendbar. Für das Oberflächenmaterial der Strukturelektrode, insbesondere für den Elektrodenkontaktbereich und/oder für den Elektrodenkomplementärbereich, kann ein Material gewählt werden, an dem die Polymerstruktur, insbesondere hinreichend gut, aber vorzugsweise nicht zu stark, haften kann. Vorteilhaft kann das Oberflächenmaterial der Strukturelektrode im Elektrodenkontaktbereich aus Platin oder Gold bestehen oder Platin oder Gold aufweisen. Beispielsweise kann die Oberfläche der Strukturelektrode im Elektrodenkontaktbereich mit einem Platin, Gold und/oder Silber aufweisenden Stoff, insbesondere durch Aufdampfung, beschichtet sein. Auch kann die Oberfläche der Strukturelektrode poliert sein. So kann die Rauheit der Oberfläche der Strukturelektrode möglichst klein oder an die zu erzielende Haftung mit der Polymerstruktur angepasst sein. Der Elektrodenkomplementärbereich der Strukturelektrode kann aus Glas bestehen. Die Kontaktierung der Elektrodenkontaktbereiche kann durch innen liegende, elektrische Leitungsverbindungen erfolgen.

Ferner hat sich gezeigt, dass bei einer Verwendung eines organischen Lösungsmittels für den ersten Elektrolyten sich die abgeschiedene Polymerstruktur besonders leicht von der ersten Elektrode lösen lässt. Eine bevorzugte Ausgestaltung des Verfahrens zeichnet sich insbesondere deshalb dadurch aus, dass der Elektrolyt ein organisches Lösungsmittel aufweist.

Durch eine geeignete Stoffwahl für das Oberflächenmaterial der Strukturelektrode, durch eine Erhöhung der mechanischen Widerstandsfähigkeit der Oberfläche der Strukturelektrode und/oder durch den gezielten Einsatz von Lösungsmitteln, insbesondere organischen Lösungsmitteln, für den ersten Elektrolyten kann es erreicht werden, dass die Strukturelektrode weder durch den Polymerisationsprozess noch durch ein Entfernen der Polymerstruktur von der Strukturelektrode angegriffen und/oder beschädigt wird. Die Strukturelektrode kann deshalb wiederholt zur Herstellung der Polymerstruktur verwendet werden. Ferner kann auch der erste, zweite und/oder dritte Elektrolyt mehrfach bis zur Erschöpfung der darin eingebrachten Verbindungen verwendet und/oder schrittweise bzw. kontinuierlich regeneriert werden.

Grundsätzlich ist eine Strukturierung der Oberfläche der Strukturelektrode nur einmal notwendig. Es können somit beliebige, insbesondere auch kostspielige, Verfahren aus dem Stand der Technik zur Strukturierung der Strukturelektrode eingesetzt werden. Der Kostenbeitrag zu den Gesamtherstellungskosten der mindestens einen Leiterbahn auf dem Substrat kann bei einer Massenproduktion aufgrund der Wiederverwendbarkeit der Strukturelektrode im Wesentlichen vernachlässigt werden. Bevorzugt wird nur dort ein leitfähiges Polymer abgeschieden, wo es durch die vorgebbare Struktur vorgesehen ist. Entsprechendes gilt auch für den Primär- und/oder Sekundärgalvanikprozess. Der Materialverbrauch und die damit verbundenen Kosten können bei der Herstellung der Metallstruktur und/oder Kontaktmetallstruktur auf dem Substrat somit auf ein Minimum beschränkt werden.

Es ist also grundsätzlich möglich, dass die Polymerstruktur zerstörungsfrei von der Strukturelektrode getrennt werden kann. Eine vorteilhafte Ausgestaltung des Verfahrens zeichnet sich dadurch aus, dass wenigstens ein Teil der an dem Substrat haftenden Kontaktmetallstruktur und/oder Metallstruktur, insbesondere zerstörungsfrei, von der Strukturelektrode abgezogen wird. Grundsätzlich kann das Substrat starr sein und/oder fest sein. Vorteilhaft ist es aber auch möglich, dass das Substrat flexibel und/oder elastisch und/oder biegbar ist. So kann das Substrat an die Form der Elektrode, Polymerstruktur, Kontaktmetallstruktur und/oder Metallstruktur anpassbar sein und/oder an diese "anschmiegbar" sein. Außerdem kann die Polymerstruktur, die Kontaktmetallstruktur und/oder die Metallstruktur stärker an dem Substrat haften als an der Strukturelektrode. Dazu kann die Oberfläche des Substrat in der Weise angepasst und/oder ausgestaltet sein, dass die Kontaktmetallstruktur stärker an dem Substrat und/oder an der Metallstruktur haftet als die Polymerstruktur an der Strukturelektrode.

Um den besonderen Vorteil einer weiteren Ausgestaltung zu erläutern, sei zunächst Folgendes erläutert. Die Strukturelektrode hat nicht nur die Aufgabe einer Elektrode. Durch die Struktur des Elektrodenkontaktbereiches, nämlich die vorgebbare Struktur, bestimmt die Strukturelektrode zumindest mittelbar auch die Struktur der Polymerstruktur, der Metallstruktur und/oder der Kontaktmetallstruktur. Die Strukturelektrode hat also zumindest zweierlei Aufgaben. Eine erste Aufgabe kann die Ermöglichung eines Stromflusses sein. Eine zweite Aufgabe kann die Formgebung der Polymerstruktur, der Metallstruktur und/oder der Kontaktmetallstruktur sein. Für zumindest eine Ausgestaltung des Verfahrens wäre es vorteilhaft, wenn die Strukturelektrode von der ersten Aufgabe befreit werden könnte, so dass der zweite oder dritte Strom nicht durch die Strukturelektrode fließt und/ oder dass die Abscheidung der Metallstruktur auf der Polymerstruktur und/oder die Abscheidung der Kontaktmetallstruktur auf der Metallstruktur unabhängig von der Strukturelektrode erfolgen kann.

Eine vorteilhafte Ausgestaltung des Verfahrens zeichnet sich durch einen Transfer wenigstens eines Teils der Polymerstruktur, wenigstens eines Teils der Kontaktmetallstruktur und/oder wenigsten eines Teils der Metallstruktur auf ein Transfersubstrat aus. Dabei kann wenigstens ein Teil der Polymerstruktur, der Metallstruktur und/oder der Kontaktmetallstruktur mit dem Transfersubstrat in Verbindung gebracht werden. Der Transfer des wenigstens einen Teils der Polymerstruktur auf das Transfersubstrat kann nach dem Polymerisationsprozess und vor dem Primärgalvanikprozess, nach dem Primärgalvanikprozess und vor dem Sekundärgalvanikprozess oder nach dem Sekundärgalvanikprozess erfolgen. Der Transfer wenigstens eines Teils der Polymerstruktur und wenigstens eines Teils der, insbesondere mit der Polymerstruktur verbundenen, Metallstruktur und/oder Kontaktmetallstruktur auf ein Transfersubstrat kann nach dem Polymerisierungsprozess und vor dem Verbindungsprozess erfolgen. Eine Verbindung der Polymerstruktur, der Metallstruktur und/oder der Kontaktmetallstruktur mit dem Transfersubstrat kann eine kraft-, form- und/oder stoffschlüssige Verbindung sein. Vorteilhaft kann wenigstens ein Teil der Polymerstruktur, wenigstens ein Teil der Metallstruktur und/oder wenigstens ein Teil der Kontaktmetallstruktur durch ein Haftmittel (Transferhaftmittel), insbesondere adhäsives Material, mit dem Transfersubstrat, vorzugsweise stoffschlüssig, verbunden sein. Das Transferhaftmittel kann so ausgewählt sein, dass das Transfersubstrat, die Polymerstruktur, die Metallstruktur und/oder die Kontaktmetallstruktur an dem Transferhaftmittel haften können. Das Transferhaftmittel kann ein selbsthärtendes Mittel sein. Auch kann das Transferhaftmittel ein unter Energiezufuhr, insbesondere thermischer Energiezufuhr, aushärtendes Haftmittel sein. Ferner kann das Transferhaftmittel ein Kleber sein. Das Transferhaftmittel kann, insbesondere für die Haftwirkung, zwischen dem Transfersubstrat und der Polymerstruktur, Metallstruktur und/oder Kontaktmetallstruktur ausgebildet sein. Auch kann das Transferhaftmittel elektrisch isolierend sein.

Außerdem kann es bevorzugt sein, dass wenigstens ein Teil der Polymerstruktur, wenigstens ein Teil der Metallstruktur und/oder wenigstens ein Teil der Kontaktmetallstruktur durch ein thermisches Fügeverfahren, insbesondere Löten, Schweißen, Laminieren und/oder Ultraschallfügen, mit dem Transfersubstrat, insbesondere stoffschlüssig, verbunden wird.

Eine weitere vorteilhafte Ausgestaltung des Verfahrens zeichnet sich dadurch aus, dass zur Bildung des Transfersubstrats eine Lösung aus einem in einem, insbesondere flüchtigen, Lösungsmittel gelösten, nicht leitfähigen Polymer (Transferpolymer), insbesondere UV härtendes Material, Thermo-Kleber oder ähnliches, auf die Polymerstruktur, die Metallstruktur, die Kontaktmetallstruktur und/oder auch auf den Elektrodenkomplementärbereich, insbesondere großflächig, aufgebracht wird. Hierbei kann das Lösungsmittel ein organisches Lösungsmittel sein. Die Verdampfungstemperatur des Lösungsmittels kann, insbesondere deutlich, niedriger als die Verdampfungstemperatur oder Sublimationstemperatur des Transferpolymers sein. Zur Bildung des Transfersubstrats kann das Lösungsmittel mit den gasförmigen Aggregatzustand überführt werden. Diese Überführung kann durch Energie- und/oder Wärmezufuhr erfolgen. Die Wärme-und/oder Energiezufuhr kann in der Weise erfolgen, dass das Transferpolymer nicht in den gasförmigen Aggregatzustand überführt wird. Auch kann das Transferpolymer so gewählt sein, dass die Polymerstruktur, die Metallstruktur und/oder die Kontaktmetallstruktur an dem Transferpolymer haften, insbesondere dass diese Strukturen, insbesondere jeweils, an dem Transferpolymer stärker haften als an der Strukturelektrode.

Bereits zuvor wurde erläutert, dass der wenigstens ein Teil der an dem Substrat zumindest mittelbar haftenden Polymerstruktur, Metallstruktur oder unmittelbar haftenden Kontaktmetallstruktur, vorzugsweise zerstörungsfrei, von der Strukturelektrode getrennt und/oder abgezogen werden kann. Außerdem wurden dazu vorteilhafte Merkmale und Zusammenhänge erläutert, die für eine zerstörungsfreie Abtrennung verantwortlich sind oder diese maßgeblich begünstigen. Entsprechendes gilt auch für das Transfersubstrat. Eine vorteilhafte Ausgestaltung des Verfahrens zeichnet sich dadurch aus, dass wenigstens ein Teil der an dem Transfersubstrat haftenden Polymerstruktur, Metallstruktur und/oder Kontaktmetallstruktur, vorzugsweise zerstörungsfrei, von der Strukturelektrode getrennt und/oder abgezogen werden kann. Eine vorteilhafte Ausgestaltung zeichnet sich insbesondere deshalb dadurch aus, dass die an dem Transfersubstrat haftende Polymerstruktur nach dem Polymerisationsprozess und vor dem Primärgalvanikprozess, insbesondere zerstörungsfrei, abgetrennt und/oder abgezogen werden kann. Eine weitere Ausgestaltungsvariante zeichnet sich dadurch aus, dass die Polymerstruktur und die Metallstruktur nach dem Primärgalvanikprozess und vor dem Sekundärgalvanikprozess und/oder vor dem Verbindungsprozess, insbesondere zerstörungsfrei, von der Strukturelektrode getrennt und/oder abgezogen werden. Außerdem kann es bevorzugt sein, dass die Polymerstruktur, die Metallstruktur und die Kontaktmetallstruktur nach dem Sekundärgalvanikprozess und vor dem Verbindungsprozess, insbesondere zerstörungsfrei, von der Strukturelektrode getrennt und/oder abgezogen werden. Durch das Transferhaftmittel können die Polymerstruktur, die Metallstruktur und/oder die Kontaktmetallstruktur stärker an dem Transfersubstrat haften als an der Strukturelektrode.

Eine weitere bevorzugte Ausgestaltung des Verfahren zeichnet sich dadurch aus, dass das Transferpolymer und/oder das Transferhaftmittel so ausgewählt wird und/oder die Oberfläche des Elektrodenkomplementärbereiches in der Weise mechanisch und/oder chemisch behandelt ist, dass der Elektrodenkomplementärbereich, insbesondere sehr schwach, an dem Transfersubstrat und/oder an dem Transferhaftmittel haftet, und/oder dass der Elektrodenkomplementärbereich, insbesondere deutlich, schwächer als die Polymerstruktur, die Metallstruktur und/oder die Kontaktmetallstruktur an dem Transfersubstrat und/oder dem Transferhaftmittel haften. Der Elektrodenkomplementärbereich kann beispielsweise antihaftbeschichtet und/oder poliert sein. Der Elektrodenkomplementärbereich kann auch eine, insbesondere sehr, geringe Rauhigkeit aufweisen. Die Oberfläche der Strukturelektrode im Bereich des Elektrodenkomplementärbereiches kann beispielsweise Teflon, Siliziumoxid oder andere isolierende Materialien aber auch elektrisch isolierte Flächen aus Gold oder Platin aufweisen und/oder aus diesen bestehen.

Eine weitere vorteilhafte Ausgestaltung des Verfahrens zeichnet sich dadurch aus, dass die Metallstruktur und/oder die Kontaktmetallstruktur und/oder zumindest ein Teil der Metallstruktur und/oder der Kontaktmetallstruktur, vorzugsweise zerstörungsfrei, von der Strukturelektrode oder von dem Transfersubstrat getrennt und/oder abgezogen werden können. Vorteilhaft, die Polymerstruktur beim Abtrennen, insbesondere von der Strukturelektrode oder von dem Transfersubstrat, eine Sollbruchstelle und/oder eine Sollbruchschicht sein. Dass die Polymerstruktur als Sollbruchstelle und/oder als Sollbruchschicht wirkt kann, ist für verschiedene (Teil-) Verfahrensschritte nutzbar. Sind die Kontaktmetallstruktur, die Metallstruktur und/oder zumindest mittelbar die Polymerstruktur, insbesondere haftend, mit dem Substrat oder dem Transfersubstrat verbunden, kann die Kontaktmetallstruktur und/oder die Metallstruktur von der Strukturelektrode oder von dem Transfersubstrat getrennt und/oder abgezogen werden, indem die Polymerstruktur unter Krafteinwirkung zwischen der Strukturelektrode und der Kontaktmetallstruktur und/oder der Metallstruktur oder zwischen dem Transfersubstrat und der Kontaktmetallstruktur und/oder der Metallstruktur zerbricht, zerreißt, sich plastisch verformt und/oder sich zumindest in zwei Teile zerteilt. Hierbei kann sich die Polymerstruktur auch in mehrere Teile aufteilen. So kann ein Teil der Polymerstruktur an der Kontaktmetallstruktur und/oder an der Metallstruktur haften. Ein anderer Teil kann an der Sfrukturelektrode oder an dem Transfersubstrat haften.

Aus dem Stand der Technik ist es grundsätzlich bekannt, dass sich die Stoffeigenschaften eines Polymers und eines metallischen Stoffes unterscheiden können. Es wäre deshalb vorteilhaft, anhand der Stoffeigenschaften eine möglichst einfache Trennung der Metallstruktur und/oder der Kontaktmetallstruktur von der Polymerstruktur, des Transfersubstrats und/oder der Strukturelektrode zu ermöglichen. Bereits zuvor wurde erläutert, dass die Polymerstruktur einer Sollbruchstelle und/oder einer Sollbruchschicht sein kann. Eine weitere vorteilhafte Ausgestaltung des Verfahrens zeichnet sich dadurch aus, dass die Metallstruktur, die Kontaktmetallstruktur, das mit der Kontaktmetallstruktur und/oder Metallstruktur verbundene Substrat und/oder das mit der Kontaktmetallstruktur und/oder Metallstruktur verbundene Transfersubstrat von zumindest einem Teil der Polymerstruktur getrennt wird, und zwar insbesondere durch ein Lösen und/oder Ätzen zumindest eines Teils der Polymerstruktur durch ein, vorzugsweise flüssiges und/oder vorzugsweise die Polymerstruktur lösendes, Lösungsmittel, das die Metallstruktur und/oder die Kontaktmetallstruktur zumindest im Wesentlichen nicht löst oder ätzt, und/oder insbesondere durch ein Verflüssigen der Polymerstruktur durch eine Energie- und/oder Wärmezufuhr, wobei die Polymerstruktur einen niedrigeren Schmelzpunkt als die Metallstruktur und/oder als die Kontaktmetallstruktur aufweist, und/oder insbesondere durch eine Überführung der Polymerstruktur in den Gaszustand durch eine Energie- und/oder Wärmezufuhr, wobei die Vergasungstemperatur oder Sublimationstemperatur der Polymerstruktur niedriger als die Schmelztemperatur der Metallstruktur und/oder der Kontaktmetallstruktur ist, und/oder insbesondere durch ein mechanisches Abtrennen, beispielsweise durch ein Wasserstrahl-, Luftstrahl-, Rakel-, Sandstrahl- und/oder Schleif-Verfahren. Durch die zuvor erläuterten Ausgestaltungen kann die Polymerstruktur, die Strukturelektrode und/oder das Transfersubstrat von der Metallstruktur und/oder von der Kontaktmetallstruktur entfernt werden. Die zuvor genannten Verfahren erlauben es also, dass die Metallstruktur und/oder die Kontaktmetallstruktur durch die Zerstörung zumindest eines Teils der Polymerstruktur oder einem anderen Gegenstand, wie beispielsweise dem Transfersubstrat, zerstörungsfrei getrennt und/oder zerstörungsfrei abgezogen werden kann. Auf diese Weise kann eine Polymerstruktur, die zwischen der Metallstruktur oder der Kontaktmetallstruktur und der Strukturelektrode oder dem Transfersubstrat ist beispielsweise durch Ätzen entfernt werden. Das Substrat, das Transfersubstrat, das Transferhaftmittel und/oder die Strukturelektrode können in der Weise ausgestaltet sein, dass sie durch das Ätzen nicht angegriffen wird und/oder beschädigt werden. Analoge Überlegungen können auch für die Temperaturabhängigkeit gelten. So kann die Polymerstruktur auf eine Temperatur erhitzt werden, bei der sie flüssig ist und/oder verdampft. Sodann kann die Metallstruktur und/oder die Kontaktmetallstruktur von dem Substrat und/oder dem Transfersubstrat getrennt werden. Denn die Polymerstruktur kann in der Weise ausgestaltet sein, dass die Polymerstruktur in einem flüssigen Aggregatzustand zumindest annähernd keine Haftwirkung und/oder zumindest nur sehr kleine Kräfte aufweist. Für eine in den gasförmigen Aggregatzustand überführte Polymerstruktur gilt dies analog, denn die vergaste Polymerstruktur weist keine Haftwirkung mehr auf.

Grundsätzlich besteht auch die Möglichkeit, dass das Substrat, die Strukturelektrode, das Transferhaftmittel und/oder das Transfersubstrat nicht ausreichend resistent gegen chemische Einwirkungen und/oder gegen ätzende Lösungen sind. Es kann deshalb auch in diesem Sinne vorteilhaft sein, eine Möglichkeit zur Verfügung zu stellen, die ein Trennen der Metallstruktur und/oder der Kontaktmetallstruktur von zumindest einem Teil der Polymerstruktur erlaubt. Eine vorteilhafte Ausgestaltung des Verfahrens zeichnet sich dadurch aus, dass die Polymerstruktur eine geringere Zug- und oder Bruchfestigkeit als die Strukturelektrode, die Strukturelektrodenoberfläche, die Kontaktmetallstruktur, die Metallstruktur, das Transferhaftmittel, das Transfersubstrat und/oder das Substrat aufweist. Die Metallstruktur und/oder die Kontaktmetallstruktur kann sodann mechanisch durch Krafteinwirkung von zumindest einem Teil der Polymerstruktur getrennt werden. Die Polymerstruktur wirkt aufgrund der geringeren Zug- und/oder Bruchfestigkeit als Sollbruchstelle und/oder Sollbruchschicht.

Eine vorteilhafte Ausgestaltung des Verfahrens zeichnet sich auch dadurch aus, dass das Transferhaftmittel in einem Lösungsmittel, insbesondere Wasser, Alkohol, Aceton, Methanol, Ethanol, Isopropanol, NMP und/oder Dichlormethan lösbar ist.

Bereits zuvor wurde erläutert, dass der Einsatz eines Transfersubstrates sinnvoll sein kann, insbesondere um die Strukturelektrode für eine wiederholte Durchführung des Verfahrens freizugeben. Grundsätzlich ist es vor dem Primärgalvanikprozess und/oder vor dem Sekundärgalvanikprozess möglich, die Polymerstruktur auf das Transfersubstrat zu transferieren. Nach dem Primärgalvanikprozess ist es (zumindest mittelbar auf der Strukturelektrode) möglich, die Metallstruktur und die Polymerstruktur auf das Transfersubstrat zu transferieren. Nach dem Sekundärgalvanikprozess ist es (zumindest mittelbar auf der Strukturelektrode) möglich, die Kontaktmetallstruktur, die Metallstruktur und die Polymerstruktur auf das Transfersubstrat zu transferieren. Ein Transfer auf das Transfersubstrat kann nach einem aus dem Stand der Technik bekannten, geeigneten Verfahren erfolgen. Eine bevorzugte Ausgestaltung des erfindungsgemäßen Verfahrens zeichnet sich dadurch aus, dass zur Bildung des Transfersubstrates, ein insbesondere organischer (beispielsweise auf Polyurethanbasis), selbst härtender, photochemisch härtender und/oder thermisch härtender Stoff, vorzugsweise Silikon- oder Heißkleber, wie beispielsweise Epoxy, auf die Polymerstruktur, die Metallstruktur, die Kontaktmetallstruktur und/oder auf den Elektrodenkomplementärbereich, insbesondere großflächig, aufgebracht wird. Hierbei kann der, vorzugsweise selbsthärtende, Stoff so ausgewählt sein, dass die Polymerstruktur, die Metallstruktur und/oder die Kontaktmetallstruktur an dem vorzugsweise selbsthärtenden Stoff haftet. Für die Haftung zwischen dem Transfersubstrat und der Polymerstruktur, der Metallstruktur und/oder der Kontaktmetallstruktur ist hier ein Transferhaftmittel nicht unbedingt notwendig. Vielmehr kann das hier dargestellte Transfersubstrat ausreichend an der Polymerstruktur, der Metallstruktur und/oder der Kontaktmetallstruktur haften. Das Transferhaftmittel kann form-, kraft- oder stoffschlüssig mit dem Transfersubstrat, der Polymerstruktur, der Metallstruktur und/oder der Kontaktmetallstruktur verbunden sein. Insbesondere deshalb kann das Transfersubstrat, insbesondere form-, kraft- oder stoffschlüssig, mit der Polymer- und/oder Metallstruktur verbunden sein. Eine derartige stoffschlüssige Verbindung kann dadurch verursacht sein, dass das Polymer des Transferpolymers eine chemische Bindung mit dem Transfersubstrat, der Polymerstruktur, der Metallstruktur und/oder der Kontaktmetallstruktur aufweist oder bildet. Ferner kann sich das Polymer des Transferpolymers während dessen Aushärtung ausdehnen, so dass sich das Transfersubstrat, die Polymerstruktur, die Metallstruktur und/oder die Kontaktmetallstruktur formschlüssig miteinander verbinden.

Findet der Transfer der Polymerstruktur nach dem Polymerisationsprozess und vor dem Primärgalvanikprozess statt, oder soll beispielsweise ein weiterer Primärgaivanikprozess nach dem Transfer der Polymerstruktur und der Metallstruktur auf das Transfersubstrat stattfinden, kann der Primärgalvanikprozess auch zumindest mittelbar auf dem Transfersubstrat stattfinden. Auch kann es bevorzugt sein, dass der Sekundärgalvanikprozess und/oder ein weiterer Sekundärgalvanikprozess zumindest mittelbar auf dem Transfersubstrat stattfindet.

Eine bevorzugte Ausgestaltung des Verfahrens zeichnet sich durch einen Primärgalvanikprozess auf der mit dem Transfersubstrat verbundenen Polymerstruktur aus. Eine weitere vorteilhafte Ausgestaltung des Verfahrens zeichnet sich durch einen Sekundärgalvanikprozess auf der mit dem Transfersubstrat zumindest mittelbar verbundenen Metallstruktur aus. Der Primärgalvanikprozess und/oder der Sekundärgalvanikprozess können auf der Polymerstruktur stattfinden, die an dem Transfersubstrat haften kann. Bei dem Primärgalvanikprozess und/oder dem Sekundärgalvanikprozess mit der Strukturelektrode kann der erste beziehungsweise zweite metallische Stoff bevorzugt auf der von der Elektrode abgewandten Seite der Polymerstruktur, der Metallstruktur und/oder der Kontaktmetallstruktur abgeschieden werden. Die Abscheidung kann in analoger Weise mit dem Transfersubstrat erfolgen. So kann bei dem Primärgalvanikprozess und/oder dem Sekundärgalvanikprozess mit dem Transfersubstrat der erste beziehungsweise zweite metallische Stoff bevorzugt auf der von dem Transfersubstrat abgewandten Seite der Polymerstruktur, der Metallstruktur und/oder der Kontaktmetallstruktur abgeschieden werden.

Bei dem Primärgalvanikprozess und/oder dem Sekundärgalvanikprozess kann die Polymerstruktur, die Metallstruktur und/oder die Kontaktmetallstruktur über den Elektrodenkontaktbereich der Elektrode elektrisch leitend kontaktiert sein. Bei einem Transfer der Polymerstruktur, der Metallstruktur und/oder der Kontaktmetallstruktur auf das Transfersubstrat kann diese Kontaktierung unterbrochen sein. Insbesondere wenn die Elektrode von der Polymerstruktur getrennt wird, besteht diese Kontaktierung nicht mehr. Insbesondere deshalb zeichnet sich eine bevorzugte Ausgestaltung des Verfahrens dadurch aus, dass die Polymerstruktur, die Metallstruktur und/oder Kontaktmetallstruktur mit dem Transfersubstrat elektrisch kontaktiert sind. Dazu kann das Transfersubstrat zumindest teilweise, insbesondere an der Oberfläche, elektrisch leitend ausgestaltet sein.

Es ist weniger bevorzugt, das zuvor beschriebene Transfersubstrat mit der daran haftenden Polymerstruktur, zumindest mittelbar anhaftenden Metallstruktur und/oder zumindest mittelbar anhaftenden Kontaktmetallstruktur mit dem zweiten oder dritten Elektrolyten in Kontakt zu bringen. Denn bei einem mit diesen Randbedingungen ausgeführten Galvanikprozess könnte der erste oder zweite metallische Stoff auch direkt auf dem Transfersubstrat abgeschieden werden. Es kann deshalb vorteilhaft sein, die unmittelbaren, insbesondere seitlichen, Zwischenräume der Polymerstruktur vor dem Eindringen eines Elektrolyten und/oder eines metallischen Stoffes zu schützen. Das kann insbesondere für den zuvor erläuterte Ausgestaltung und/oder für eine andere Ausgestaltung des Verfahrens sinnvoll sein.

Eine bevorzugte Ausgestaltung des Verfahrens zeichnet sich durch ein Füllen der, insbesondere seitlich erstreckenden, Zwischenräume der Polymerstruktur aus. Hierbei kann eine Lösung aus einem in einem, insbesondere flüchtigen, Lösungsmittel gelösten, nicht leitfähigen Polymer auf wenigstens einen Teil des nicht von der Polymerstruktur, der Metallstruktur und/oder der Kontaktmetallstruktur abgedeckten Bereiches der Elektrode (insbesondere also der Komplementärbereich) oder des Transfersubstrates aufgebracht werden. Die Lösung kann dabei zunächst großflächig auf der Polymerstruktur und/oder auf beziehungsweise in die Zwischenräume verteilt werden. Danach kann die Oberfläche der Polymerstruktur, der Metallstruktur und/oder der Kontaktmetallstruktur abgezogen werden. Auf diese Weise kann erreicht werden, dass die Lösung und/oder das nichtleitfähige Polymer nur in den Zwischenräumen der Polymerstruktur, der Metallstruktur und/oder der Kontaktmetallstruktur ist. Das flüchtige Lösungsmittel kann danach in den gasförmigen Aggregatzustand, insbesondere durch Energie- und/oder Wärmeenergiezufuhr, überführt werden. Es ist also möglich, dass das Transfersubstrat großflächig eine elektrisch leitende Oberfläche aufweist. Mit dieser kann die Polymerstruktur, die Metallstruktur und/oder die Kontaktmetallstruktur, insbesondere elektrisch leitend, verbunden sein. Die Zwischenräume der Polymerstruktur können elektrisch isolierend ausgestaltet sein. Dadurch ist es möglich, dass das Transfersubstrat mit der Polymerstruktur, der Metallstruktur und/oder der Kontaktmetallstruktur in Kontakt mit einem zweiten oder dritten Elektrolyten gebracht werden kann und der Primärgalvanikprozess beziehungsweise der Sekundärgalvanikprozess ausgeführt werden kann, wobei sich durch einen zweiten Strom der erste metallische Stoff aus dem zweiten Elektrolyten auf der Polymerstruktur, der Metallstruktur und/oder der Kontaktmetallstruktur und/oder sich durch einen dritten Strom der zweite metallische Stoff aus dem dritten Elektrolyten auf der Polymerstruktur, der Metallstruktur und/oder der Kontaktmetallstruktur abscheidet. Hier findet insbesondere keine direkte Metallabscheidung auf dem Transfersubstrat statt. Denn das Transfersubstrat kann mit der Polymerstruktur und in den entsprechenden Komplementärbereichen mit einem elektrisch isolierenden Stoff, insbesondere einem Polymer, bedeckt sein. Auch kann es bevorzugt sein, dass der Elektrodenkontaktbereich isolierend ausgestaltet ist und/oder ein Isolator ist.

Eine Kontaktierung der elektrisch leitenden Oberfläche des Transfersubstrates kann durch laterale Anschlüsse und/oder durch innen angeordnete elektrische Leitungsverbindungen erfolgen. Die elektrisch leitende Oberfläche des Transfersubstrates kann so mit einem Spannungspotential verbindbar sein.

Eine weitere bevorzugte Ausgestaltung des Verfahrens zeichnet sich dadurch aus, dass die Strukturelektrode und/oder das Transfersubstrat eine Rolle, ein Band, ein Wafer, eine Platte und/oder ein Kettenglied ist. Das Verfahren kann auch ein kontinuierliches Verfahren sein. Die Strukturelektrode oder das Transfersubstrat kann so beispielsweise kontinuierlich durch den ersten, zweiten und/oder dritten Elektrolyten geführt oder gedreht werden. Für eine weitere bevorzugte Ausgestaltung kann die Strukturelektrode mehrere Oberflächenteilgebiete aufweisen. Die Oberflächenteilgebiete der Strukturelektrode können beweglich zueinander ausgestaltet sein. Auch können die Oberflächenteilgebiete der Strukturelektrode flexibel, separat, gruppenweise und/oder in Abhängigkeit der vorgegebenen Struktur, insbesondere elektrisch, ansteuerbar und/oder bestrombar sein.

Für weitere bevorzugte Ausgestaltungen der Erfindung ist des Weiteren der Gegenstand der deutschen Patentanmeldung DE 10 2009 010 434.8 in vollem Umfang, insbesondere die dort vorteilhaft offenbarten Einzelheiten, Vorteile und Merkmale der Vorrichtung und/oder des Verfahren zur Herstellung von elektrisch leitfähigen Leiterbahnen, auch Gegenstand dieser Patentanmeldung.

Eine weitere bevorzugte Ausgestaltung des Verfahrens zeichnet sich dadurch aus, dass der Elektrodenkontaktbereich und/oder der Elektrodenkomplementärbereich jeweils aus nicht zusammenhängenden Oberflächen der Strukturelektrode gebildet ist. Bevorzugt können einzelne Oberflächenbereiche separat und/oder gruppenweise, insbesondere jeweils, mit einem elektrischen Potential steuerbar verbindbar sein. Die vorgebbare Struktur kann somit durch Steuern der Verbindungen und/oder der Spannungen auf die Strukturelektrode übertragen und/oder projiziert werden. Vorteilhaft können der Elektrodenkontaktbereich und der Elektrodenkomplementärbereich durch einen, insbesondere sehr, schmalen Elektrodenisolationsbereich von einander getrennt sein. Außerdem können, insbesondere nur, die Elektrodenkontaktbereiche mit einem ersten Spannungspotential verbindbar sein. Insbesondere hierbei kann es bevorzugt sein, dass der Elektrodenkomplementärbereich mit einem zweiten Spannungspotential verbindbar ist, insbesondere wobei dessen Spannung niedriger ist als die des ersten Spannungspotentials. Das zweite Spannungspotential kann auch eine negative Spannung aufweisen.

Eine weitere bevorzugte Ausgestaltung des Verfahrens zeichnet sich dadurch aus, dass der erste und/oder der zweite metallische Stoff eine Opferelektrode und/oder mindestens einen Teil der Oberflächenschicht der Opferelektrode bildet. Bevorzugt kann für den Primärgalvanikprozess und den Sekundärgalvanikprozess das gleich und/oder das selbe Lösungsmittel verwendet werden. Ferner ist es möglich, dass der erste und zweite metallische Stoff der gleiche Stoff, weniger bevorzugt der selbe Stoff, ist.

Eine weitere bevorzugte Ausgestaltung des Verfahrens zeichnet sich dadurch aus, dass der Primärgalvanikprozess und/oder der Sekundärgalvanikprozess separat und/oder als Gruppenprozess, insbesondere mehrfach, vor dem Verbindungsprozess wiederholt werden.

## Ausführungsbeispiele:

Weitere Einzelheiten, Vorteile und Merkmale der Erfindung gehen aus der nachfolgenden Figuren und/oder aus der Beschreibung der Figuren hervor. Dabei zeigen:

**Figur 1** einen Ablaufplan mit verschiedenen Ausgestaltungsmöglichkeiten zur Ausführung des erfindungsgemäßen Verfahrens,

**Figur 2**   eine Querschnittsansicht einer Strukturelektrode mit Leitungsverbindun- gen zur Kontaktierung,

**Figur 3**   eine Schnittansicht einer Strukturelektrode,

**Figur 4**   eine schematische Darstellung einer Polymerisationsstation zur Durch- führung eines Polymerisationsprozesses,

**Figur 5**   eine Schnittansicht einer Strukturelektrode mit einer Polymerstruktur,

**Figur 6**   eine schematische Darstellung einer Galva- nikstation zur Durchführung eines Galvanik- prozesses,

**Figur 7**   eine Schnittansicht einer Strukturelektrode mit einer Polymerstruktur und einer Metallstruktur,

**Figur 8**   eine Schnittansicht einer Strukturelektrode mit einer Polymerstruktur, einer Metallstruktur und einer Kontaktmetallstruktur,

**Figur 9**   eine Schnittansicht einer Strukturelektrode mit einer Polymerstruktur, einer Metallstruktur und einer Kontaktmetallstruktur in Verbindung mit ei- nem Substrat,

**Figur 10**   eine Schnittansicht einer Sollbruchstelle durch die Polymerstruktur, die zumindest teilweise mit der Strukturelektrode und der Kontaktmetallstruk- tur verbunden ist,

**Figur 11**   eine Schnittansicht von Leiterbahnen auf dem Substrat und

**Figur 12**   eine schematische Darstellung elektrischer Leiterbahnen auf einem Sub- strat einer Solarzelle.

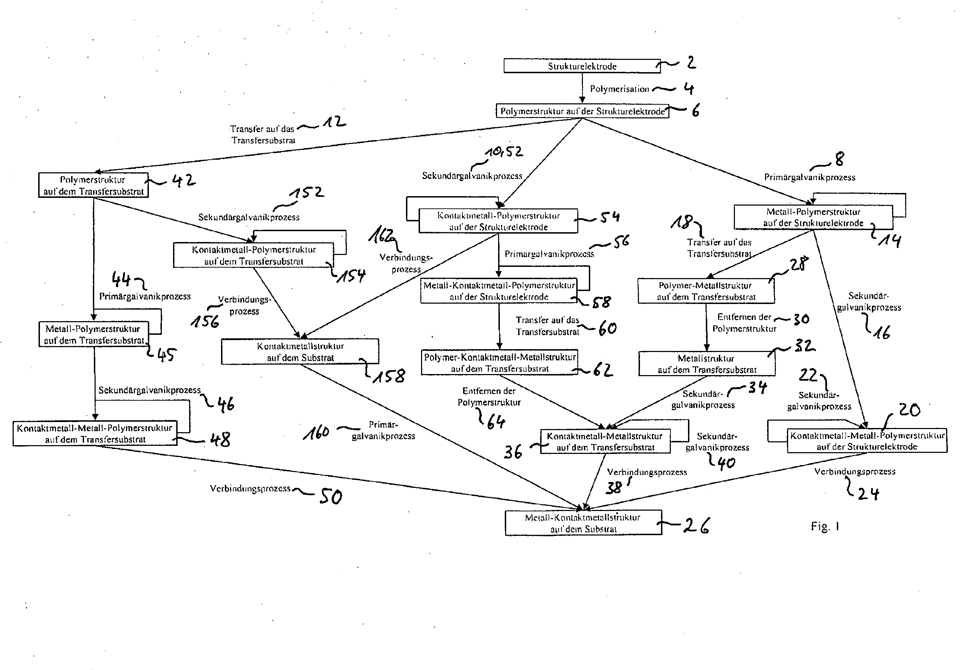

In der Figur 1 ist ein Ablaufplan dargestellt, der mehrere bevorzugte Wege zur Ausführung des erfindungsgemäßen Verfahrens zeigt. Bevor im Weiteren auf diese Wege konkret eingegangen wird, werden zunächst die verwendeten Zeichen zur schematischen Darstellung des Ablaufplans erklärt. In einem Rechteck kann ein Ausgangs-oder Zielzustand dargestellt sein. Die Rechtecke sind jeweils durch Pfeile miteinander verbunden. Die Pfeilrichtung zeigt die bevorzugten Zustandsänderungen an. Neben den Pfeilen sind die Operationen dargestellt, durch die die jeweilige Zustandsänderung bewirkt werden kann.

Um das bevorzugte Ziel des erfindungsgemäßen Verfahrens zu erreichen, nämlich mindestens eine Leiterbahn auf dem Substrat, wird zunächst von dem Vorhandensein einer Strukturelektrode **2** ausgegangen. Mit Hilfe der Strukturelektrode **2** wird eine Polymerisation **4** ausgeführt. Durch die Polymerisation **4** erfolgt eine elektrochemische Abscheidung eines leitfähigen Polymers auf der Strukturelektrode **2.** Diese Abscheidung erfolgt zumindest im Wesentlichen nur in den Bereichen der vorgebbaren Struktur. Diese vorgebbare Struktur ist der Elektrodenkontaktbereich. Das leitfähige Polymer wird also auf dem Elektrodenkontaktbereich der Strukturelektrode **2** abgeschieden. Somit kann auch von einer Polymerstruktur auf der Strukturelektrode **6** gesprochen werden, die zugleich der Ausgangszustand einer Verzweigung für drei alternative, nachfolgende Verfahrensschritte ist. Denn mit der Polymerstruktur auf der Strukturelektrode **6** kann ein Primärgalvanikprozess **8,** ein Sekundärgalvanikprozess **10** oder ein Transfer auf das Transfersubstrat **12** ausgeführt werden.

Zunächst wird im Weiteren der Weg beginnend mit dem Primärgalvanikprozess **8** verfolgt. Die beiden alternativen Verfahrensschritte werden in einem späteren Kapitel erörtert. Durch den Primärgalvanikprozess **8** wird ein erster metallischer Stoff auf der Polymerstruktur abgeschieden. Auf den zu der Polymerstruktur komplementären Bereichen wird kein oder annähernd kein metallischer Stoff abgeschieden. Durch den Polymerisationsprozess **4** und den Primärgalvanikprozess **8** hat die Strukturelektrode **2** Kontakt mit einem Mehrschichtmaterial, beziehungsweise ist mit einem Mehrschichtmate- rial verbunden. Denn die Strukturelektrode ist zunächst mit der Polymerstruktur verbunden. Auf der von der Strukturelektrode abgewandten Seite ist die Polymer- struktur mit der Metallstruktur verbunden. Somit ist die Metallstruktur zumindest mittelbar auch mit der Strukturelektrode verbunden. Aufgrund der Anordnung der Materialien, nämlich dass die Strukturelektrode zumindest mit der Polymerstruktur verbunden ist und diese wiederum mit der Metallstruktur, kann diese Anordnung im Weiteren auch als "Metall-Polymerstruktur auf der Strukturelektrode" **14** bezeichnet sein. Die Nomenklatur der Bezeichnung richtet sich an die Anordnung der Stoffe und/ oder Schichten, und zwar von außen nach innen.

Auch die Metall-Polymerstruktur auf der Strukturelektrode **14** ist zugleich ein Ausgangszustand einer Verzweigung für drei alternative, nachfolgende Verfahrensschritte. Denn mit der Metall-Polymerstruktur auf der Strukturelektrode **14** kann ein (insbesondere weiterer) Primärgalvanikprozess **8,** ein Sekundärgalvanikprozess **16** oder ein Transfer auf das Transfersubstrat 18 ausgeführt werden.

Zunächst wird im Weiteren der Weg beginnend mit dem Sekundärgalvanikprozess **16** verfolgt. Die beiden alternativen Verfahrensschritte werden in einem späteren Kapitel erörtert. Mit der Metall-Polymerstruktur auf der Strukturelektrode **14** kann der Sekundärgalvanikprozess **16** ausgeführt werden, wobei eine metallische Schicht aus dem zweiten metallischen Stoff zumindest im Wesentlichen auf der Metallstruktur abgeschieden wird. Diese weitere metallische Schicht bildet die Kontaktmetallstruktur. Die Kontaktmetallstruktur ist mit der Metallstruktur verbunden. Durch den Verbund von Polymerstruktur, Metallstruktur und Kontaktmetallstruktur ist auch die Kontaktmetallstruktur mit der Strukturelektrode verbunden. Somit führt der Sekundärgalvanikprozess **16** zu einer Kontaktmetall-Metall-Polymerstruktur auf der Strukturelektrode **20**. Auch die Kontaktmetall-Metall-Polymerstruktur auf der Strukturelektrode **20** ist zugleich ein Ausgangszustand einer Verzweigung für zwei alternative, nachfolgende Verfahrensschritte. Denn mit der Kontaktmetall-Metall-Polymerstruktur auf der Strukturelektrode **20** kann ein Sekundärgalvanikprozess **22** oder ein Verbindungsprozess **24** ausgeführt werden.

Im Weiteren wird der Weg beginnend mit dem Verbindungsprozess **24** verfolgt. Der alternative Verfahrensschritt, nämlich der Sekundärgalvanikprozess **22,** wird in einem späteren Kapitel erörtert. Durch den Verbindungsprozess **24** wird die Kontaktmetall-Metall-Polymerstruktur auf der Strukturelektrode **20** mit dem Substrat verbunden. Dazu kann die Köntaktmetallstruktur so hoch erwärmt werden, dass diese schmilzt. In dem flüssigen Zustand der Kontaktmetallstruktur kann diese mit dem Substrat in Verbindung gebracht werden. Danach kann die Kontaktmetallstruktur abkühlen bzw. dieser Energie und/oder Wärme entzogen werden, sodass die Kontaktmetallstruktur erstarrt. Auf diese Weise kann die Metallstruktur mit dem Substrat verbunden werden. Durch den Verbindungsprozess **24** entsteht deshalb die Metall-Kontaktmetallstruktur auf dem Substrat **26**. Soweit wurde ein möglicher Weg ausgehend von der Strukturelektrode **2** zur Herstellung einer Leiterbahn, nämlich einer Metall-Kontaktmetallstruktur, auf einem Substrat **26** erläutert. Dafür wurden bei mehreren Verzweigungen bestimmte Wege ausgewählt. Auf die alternativen Wege der jeweiligen Verzweigungen wird in den folgenden Abschnitten eingegangen. Um den jeweiligen "Einstieg" zu finden, wird dazu jeweils der entsprechende Ausgangszustand genannt. Die alternativen Wege werden danach jeweils so weit beschrieben, bis wieder ein bereits beschriebener Zustand erreicht ist.

Ausgehend von der Metall-Polymerstruktur auf der Strukturelektrode **14** kann ein Transfer auf das Transfersubstrat **18** ausgeführt werden. Hierbei kann die Metallstruktur beispielsweise durch ein Transferhaftmittel mit dem Transfersubstrat verbunden werden. Bei ausreichender Haftwirkung zwischen dem Transfersubstrat und der Metallstruktur sowie zwischen der Metallstruktur und der Polymerstruktur kann die Polymerstruktur von der Strukturelektrode abgezogen werden. Durch den Transfer auf das Transfersubstrat **18** entsteht somit also eine Polymer-Metallstruktur auf dem Transfersubstrat **28**. Die Nomenklatur "Polymer-Metallstruktur" ist konform zu der Bezeichnung "Metall-Polymerstruktur", denn ausgehend von der Strukturelektrode wurde die Schichtfolge der Metallstruktur und der Polymerstruktur für das Transfersubstrat getauscht bzw. invertiert. Danach erfolgt ein Entfernen der Polymerstruktur **30,** sodass eine Metallstruktur auf dem Substrat **32** entsteht. Die Polymerstruktur kann hierbei thermisch entfernt sein. Beispielsweise kann diese durch Wärmezufuhr in den Gaszustand überführt worden sein. Mit der Metallstruktur auf dem Transfersubstrat **32** wird danach ein Sekundärgalvanikprozess **34** ausgeführt. Durch den Sekundärgalvanikprozess **34** wird eine Schicht aus dem zweiten metallischen Stoff auf der Metallstruktur abgeschieden. Unter Berücksichtigung der zuvor eingeführten Nomenklatur entsteht dadurch eine Kontaktmetall-Metallstruktur auf dem Transfersubstrat **36**. Dies ist zugleich ein Ausgangszustand einer weiteren Verzweigung für zwei alternative, nachfolgende Verfahrensschritte. Denn mit der Kontaktmetall-Metallstruktur auf dem Transfersubstrat **36** kann ein Verbindungsprozess **38** oder ein Sekundärgalvanikprozess **40** ausgeführt werden.

Zunächst wird im Weiteren der Weg beginnend mit dem Verbindungsprozess **38** verfolgt. Der alternative Verfahrensschritt, nämlich hier der Sekundärgalvanikprozess **40,** wird in einem späteren Kapitel erörtert. Durch den Verbindungsprozess **38** kann die Kontaktmetallstruktur der Kontaktmetall-Metallstruktur auf dem Substrat **36** mit dem Substrat verbunden werden. Die Kontaktmetallstruktur kann dazu zunächst durch Energie- und/oder Wärmezufuhr in einen flüssigen Aggregatzustand überführt werden, wobei danach das Substrat mit der Kontaktmetallstruktur kontaktiert wird. Durch Energie- und/oder Wärmeentzug erstarrt die Kontaktmetallstruktur und verbindet sich mit dem Substrat. Das Transfersubstrat kann danach entfernt werden. Insbesondere kann das Transfersubstrat danach abgezogen werden. Durch den Verbindungsprozess **38** entsteht deshalb die Metall-Kontaktmetallstruktur auf dem Substrat **26**.

Um einen alternativen Wegabschnitt zu erläutern, wird zurück zu der Verzweigung gesprungen, die von der Polymerstruktur auf der Strukturelektrode **6** ausgeht. Von hier aus beginnend wird der Weg verfolgt, der mit dem Transfer auf das Transfersubstrat **12** beginnt. Hierbei wird die Polymerstruktur auf ein Transfersubstrat transferiert und/oder übertragen. Die Polymerstruktur kann dazu durch ein Transferhaftmittel mit dem Transfersubstrat, insbesondere haftend, verbunden werden und bevorzugt mit dem Transfersubstrat von der Strukturelektrode abgezogen werden. Somit entsteht eine Polymerstruktur auf dem Transfersubstrat **42**. Die Polymerstruktur kann seitlich und/oder lateral elektrisch mit einem elektrischen Potential kontaktiert sein. Außerdem ist es auch möglich, dass die Polymerstruktur durch das Transfersubstrat elektrisch kontaktiert ist. Mit der Polymerstruktur auf dem Transfersubstrat **42** kann deshalb der Primärgalvanikprozess **44** oder der Sekundärgalvanikprozess **152** ausgeführt werden. Somit ist auch die Polymerstruktur auf dem Transfersubstrat **42** ist zugleich ein Ausgangszustand einer Verzweigung für zwei alternative, nachfolgende Verfahrensschritte.

Zunächst wird im Weiteren der Weg beginnend mit dem Primärgalvanikprozess **44** verfolgt. Der alternative Verfahrensschritte werden in einem späteren Absatz erörtert. Durch den Primärgalvanikprozess **44** wird eine metallische Schicht aus dem ersten metallischen Stoff auf der Polymerstruktur abgeschieden. Durch die geometrische Anordnung der Polymerstruktur überträgt die Polymerstruktur während des Primärgalvanikprozesses die vorgebbare Struktur an die metallische Schicht, sodass durch die sich abscheidende metallische Schicht die Metallstruktur entsteht. Durch den Primärgalvanikprozess **44** mit der Polymerstruktur auf dem Transfersubstrat **42** wird deshalb die Metall-Polymerstruktur auf dem Transfersubstrat **45** hergestellt, die zugleich ein Ausgangszustand einer Verzweigung für zwei alternative, nachfolgende Verfahrensschritte ist. Denn mit der Metall-Polymerstruktur auf dem Transfersubstrat **45** kann ein Primärgalvanikprozess **44** oder ein Sekundärgalvanikprozess **46** ausgeführt werden.

Zunächst wird im Weiteren der Weg beginnend mit dem Sekundärgalvanikprozess **46** verfolgt. Der alternative Verfahrensschritt, nämlich hier der Primärgalvanikprozess **44,** wird in einem späteren Kapitel erörtert. Durch den Sekundärgalvanikprozess **46** wird auf der Metallstruktur eine weitere metallische Schicht aus dem zweiten metallischen Stoff elektrolytisch abgeschieden. Diese weitere metallische Schicht ist die Kontaktmetallstruktur. Die Metallstruktur ist für den Sekundärgalvanikprozess durch die Polymerstruktur elektrisch kontaktiert. Die Polymerstruktur selbst ist bevorzugt durch das Transfersubstrat elektrisch mit einem elektrischen Potential kontaktiert. Durch den Sekundärgalvanikprozess **46** entsteht die Kontaktmetall-Metall-Polymerstruktur auf dem Transfersubstrat **48.** Insbesondere die mehrschichtige Struktur kann durch den Verbindungsprozess **50** auf ein Substrat übertragen werden. Dazu ist es bevorzugt, dass die Kontaktmetallstruktur in einen flüssigen Zustand überführt und mit dem Substrat kontaktiert wird, um danach durch Wärme- und/oder Energieentzug zu erstarren, sodass sich die Kontaktmetallstruktur und die Metallstruktur mit dem Substrat verbinden. Bevorzugt wird danach das Transfersubstrat und/oder die Polymerstruktur entfernt. Das Transfersubstrat und/oder die Polymerstruktur können auch vor dem Verbindungsprozess **50** entfernt werden. Durch den Verbindungsprozess **50** entsteht aus der Kontakt-metall-Metall-Polymerstruktur auf dem Substrat **48** die Metall-Kontaktmetällstruktur auf dem Substrat **26.**

Um einen weiteren alternativen Wegabschnitt zu erläutert, wird wieder zu der Polymerstruktur auf der Strukturelektrode **6** gesprungen, um den Weg beginnend mit dem Sekundärgalvanikprozess **10** zu erläutern. Da die Polymerstruktur bevorzugt mit dem Elektrodenkontaktbereich der Strukturelektrode elektrisch leitend verbunden ist, kann durch den Sekundärgalvanikprozess auf der Polymerstruktur eine metallische Schicht aus dem zweiten metallischen Stoff elektrolytisch abgeschieden werden. Es entsteht somit eine Kontaktmetall-Polymerstruktur auf der Strukturelektrode **54.** Auch dieser Zustand ist zugleich ein Ausgangszustand einer Verzweigung für drei alternative, nachfolgende Verfahrensschritte. Die alternativen Verfahrensschritte sind der Sekundärgalvanikprozess **52,** der Primärgalvanikprozess **56** und der Verbindungsprozess **162.** Die Wege beginnend mit dem Sekundärgalvanikprozess **52** und dem Verbindungsprozess **162** werden in späteren Absätzen erörtert. Zunächst wird im Weiteren der Weg beginnend mit dem Primärgalvanikprozess **56** verfolgt.

Durch den Primärgalvanikprozess **56** kann auf der Kontaktmetallstruktur eine weitere metallische Schicht aus dem ersten metallischen Stoff elektrolytisch abgeschieden werden. Es entsteht deshalb eine Metall-Kontaktmetall-Polymerstruktur auf der Strukturelektrode **58.** Durch einen Transfer auf das Transfersubstrat **60** kann zumindest die Metall-Kontaktmetall-Polymerstruktur auf das Transfersubstrat transferiert und/oder übertragen werden. Dazu kann die Metallstruktur durch ein Transferhaftmittel mit dem Transfersubstrat, insbesondere haftend, verbunden werden. Ferner kann die Metall-Kontaktmetall-Polymerstruktur von der Strukturelektrode abgezogen werden. Die Polymer-Kontaktmetall-Metallstruktur auf dem Transfersubstrat **62** ist also von der Strukturelektrode getrennt. Durch ein Entfernen der Polymerstruktur **64** kann die Polymerstruktur der Polymer-Kontaktmetall-Metallstruktur auf dem Transfersubstrat **62** entfernt werden. Das Entfernen kann insbesondere durch Energie- und/oder Wärmezufuhr erfolgen, wobei die Polymerstruktur in den gasförmigen Aggregatzustand überführt werden kann. Durch das Entfernen der Polymerstruktur **64** entsteht die Kontaktmetall-Metallstruktur auf dem Transfersubstrat **36.** Dieser Zustand wurde bereits zuvor erläutert. Die Kontaktmetall-Metallstruktur auf dem Transfersubstrat **36** kann durch einen Verbindungsprozess **38** in der Weise mit dem Substrat verbunden werden, dass die Metall-Kontaktmetallstruktur auf dem Substrat **26** entsteht.

Um einen weiteren alternativen Wegabschnitt, beginnend mit dem Sekundärgalvanikprozess **152,** zu erläutern, wird zurück zu der Polymerstruktur auf dem Transfersubstrat **42** gesprungen. Die Polymerstruktur kann seitlich und/oder lateral elektrisch mit einem elektrischen Potential kontaktiert sein. Auch ist es auch möglich, dass die Polymerstruktur durch das Transfersubstrat elektrisch kontaktiert ist. Mit der Polymerstruktur auf dem Transfersubstrat **42** kann deshalb der Sekundärgalvanikprozess **152** ausgeführt und auf der Polymerstruktur eine metallische Schicht aus dem zweiten metallischen Stoff elektrolytisch abgeschieden werden. Durch die geometrische Anordnung der Polymerstruktur überträgt die Polymerstruktur während des Sekundärgalvanikprozesses die vorgebbare Struktur an die metallische Schicht, sodass durch die sich abscheidende metallische Schicht die Kontaktmetallstruktur entsteht. Es entsteht somit eine Kontaktmetall-Polymerstruktur auf dem Transfersubstrat **154.** Auch dieser Zustand ist zugleich ein Ausgangszustand einer Verzweigung für zwei alternative, nachfolgende Verfahrensschritte. Die alternativen Verfahrensschritte sind der Sekundärgalvanikprozess **152** und der Verbindungsprozess **156**. Der Weg beginnend mit dem Sekundärgalvanikprozess **152** wird in einem späteren Absatz erörtert. Zunächst wird im Weiteren der Weg beginnend mit dem Verbindungsprozess **156** verfolgt.

Durch den Verbindungsprozess **156** kann die Kontaktmetallstruktur der Kontaktmetallstruktur auf dem Transfersubstrat **154** mit dem Substrat verbunden werden. Die Kontaktmetallstruktur kann dazu zunächst durch Energie- und/oder Wärmezufuhr in einen flüssigen Aggregatzustand überführt werden, wobei danach das Substrat mit der Kontaktmetallstruktur kontaktiert wird. Durch Energie- und/oder Wärmeentzug erstarrt die Kontaktmetallstruktur und verbindet sich mit dem Substrat. Das Transfersubstrat kann danach entfernt werden. Insbesondere kann das Transfersubstrat danach abgezogen werden. Durch den Verbindungsprozess **156** entsteht deshalb die Kontaktmetallstruktur auf dem Substrat **158**. Durch den anschließenden Primärgalvanikprozess **160** kann auf der Kontaktmetallstruktur eine weitere metallische Schicht aus dem ersten metallischen Stoff elektrolytisch abgeschieden werden. Die Kontaktmetallstruktur kann seitlich und/oder lateral elektrisch mit einem elektrischen Potential kontaktiert sein. Auch ist es auch möglich, dass die Kontaktmetallstruktur durch das Substrat elektrisch kontaktiert ist. Durch den Primärgalvanikprozess **160** entsteht deshalb eine Metall-Kontaktmetallstruktur auf dem Substrat **26**.

Um einen weiteren alternativen Wegabschnitt, beginnend mit dem Verbindungsprozess **162,** zu erläutert, wird zurück zu der Kontaktmetall-Polymerstruktur auf der Strukturelektrode **54** gesprungen. Durch den Verbindungsprozess **162** kann die Kontaktmetallstruktur der Kontaktmetall-Polymerstruktur auf der Strukturelektrode **54** mit dem Substrat verbunden werden. Die Kontaktmetallstruktur kann dazu zunächst durch Energie- und/oder Wärmezufuhr in einen flüssigen Aggregatzustand überführt werden, wobei danach das Substrat mit der Kontaktmetallstruktur kontaktiert wird. Durch Energie- und/oder Wärmeentzug erstarrt die Kontaktmetallstruktur und verbindet sich mit dem Substrat. Die Polymerstruktur und die Strukturelektrode können danach entfernt werden. Insbesondere kann die Strukturelektrode danach abgezogen werden. Durch den Verbindungsprozess **162** entsteht deshalb die Kontaktmetallstruktur auf dem Substrat **158**.

Bisher nicht erläutert wurden die Primärgalvanikprozesse **8, 44, 56** und die Sekundärgalvanikprozesse **22, 40, 46, 52, 152**. Allen gemeinsam ist, dass der jeweilige Primärgalvanikprozess oder Sekundärgalvanikprozess auf den deren Ausgangszustand zurückführt. Gemeint ist damit zumindest im Wesentlichen, dass der Primärgalvanikprozess oder der Sekundärgalvanikprozess jeweils mehrfach nacheinander ausgeführt werden kann. Auf eine Metallstruktur, die durch einen Primärgalvanikprozess erstellt wurde, kann danach durch einen weiteren Primärgalvanikprozess eine weitere Metallstruktur abgeschieden werden. Die nacheinander und/oder aufeinander abgeschieden Metallstrukturen können als eine einheitliche Metallstruktur aufgefasst werden. Analoge Überlegungen gelten für den Sekundärgalvanikprozess. So kann ein Sekundärgalvanikprozess mehrfach nacheinander ausgeführt werden. Auf einer Kontaktmetallstruktur, die durch einen Sekundärgalvanikprozess erstellt wurde, kann eine weitere Kontaktmetallstruktur durch einen weiteren Sekundärgalvanikprozess abgeschieden werden. Mehrere nacheinander und/ oder aufeinander abgeschiedene Kontaktmetallstrukturen können als eine einheitliche Kontaktmetallstruktur aufgefasst werden. Die zuvor erläuterten Zusammenhänge gelten bevorzugt für die Primärgalvanikprozesse **8, 44, 56** und für die Sekundärgalvanikprozesse **22, 40, 46, 52, 152**.

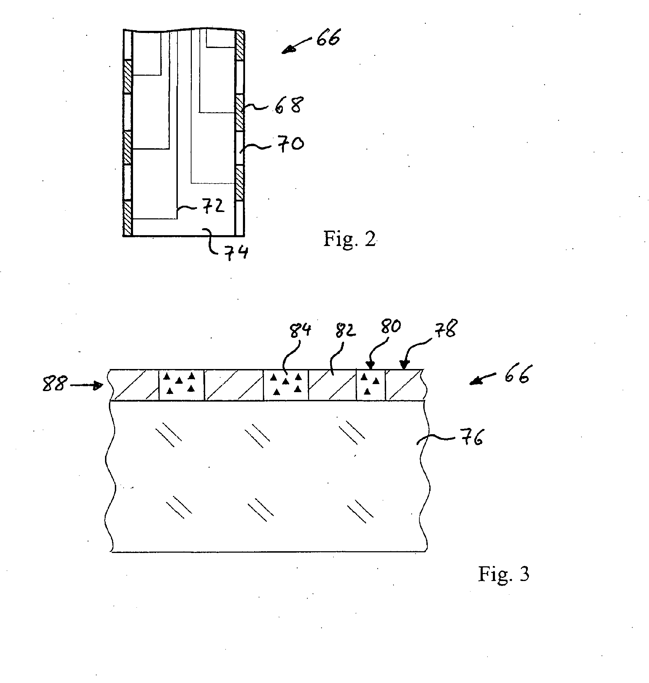

In der Figur 3 ist eine Schnittansicht einer Strukturelektrode **66** dargestellt. Die Strukturelektrode **66** weist ein Trägermaterial **76** auf, das insbesondere den Kern der Strukturelektrode bilden kann. Auf das Trägermaterial **76** ist eine Funktionsträgerschicht **88** aufgebracht. Die Funktionsträgerschicht **88** weist einen mehrteiligen leitfähigen Elektrodenkontaktbereich **82** und einen mehrteiligen, nicht leitfähigen Elektrodenkomplementärbereich **84** auf. In einer bevorzugten Ausführungsform ist die Trägerschicht **76** aus hochdotiertem Silizium, der leitfähige Elektrodenkontaktbereich **82** aus Chrom/Gold und der nicht leitfähige Elektrodenkomplementärbereich **84** aus einem isolierenden Stoff, insbesondere aus oxidiertem Silizium. Die von dem Trägermaterial **76** wegweisende Oberfläche des Elektrodenkontaktbereiches **82** ist eine mehrteilige, leitfähige Elektrodenoberflächenschicht **82**. Die von dem Trägermaterial **76** wegweisende Oberfläche des Elektrodenkomplementärbereichs ist eine mehrteilige, nicht leitfähige Elektrodenoberflächenschicht **80**. Der Elektrodenkontaktbereich **82** und der Elektrodenkomplementärbereich **84** können jeweils auch einzelne Teiloberflächen der Strukturelektrode bilden oder sein.

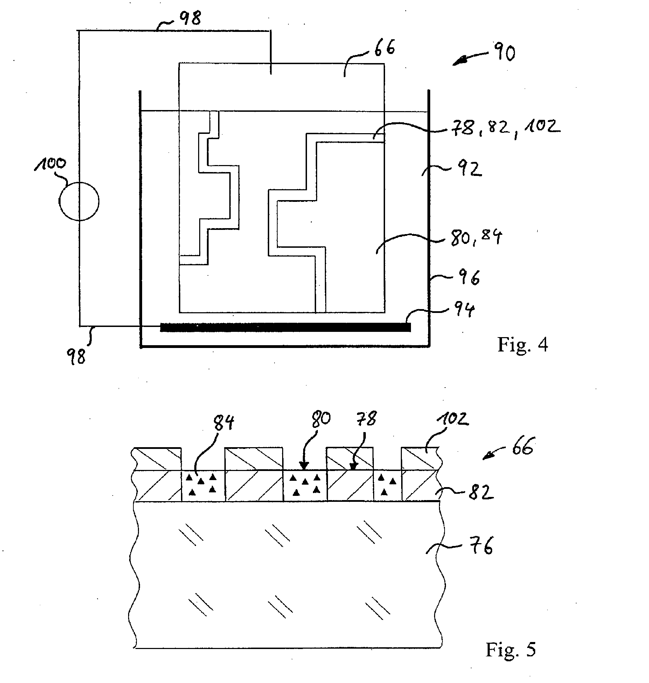

In der Figur 4 ist eine schematische Darstellung einer Polymerisationsstation **90** zur Durchführung eines Polymerisationsprozesses gezeigt. Die Strukturelektrode **66** ist zumindest teilweise in den ersten Elektrolyten **92** eingetaucht und/oder in Kontakt mit diesem gebracht. Der erste Elektrolyt **92** ist hierbei von einem Behälter **96** aufgenommen. Außerdem ist die Strukturelektrode **66** zumindest soweit mit dem ersten Elektrolyten **92** in Kontakt gebracht, dass zumindest auch Teile des Elektrodenkontaktbereiches **82** und des Elektrodenkomplementärbereiches **84** der Strukturelektrode **66** mit dem ersten Elektrolyten **92** in Kontakt gebracht sind. Außerdem ist eine Gegenelektrode **94** mit dem ersten Elektrolyten **92** in Kontakt gebracht. Die Strukturelektrode **66** und die Gegenelektrode **94** sind durch elektrische Leitungsverbindungen **98** mit einer Spannungsquelle **100** verbunden. Mit der Polymerisationsstation **90** wird durch eine elektrochemische Polymerisation ein elektrisch leitfähiges Polymer auf dem Elektrodenkontaktbereich **82** abgeschieden. Dazu wird eine Spannung zwischen der Strukturelektrode **66** und der Gegenelektrode **94** angelegt.

So kann für ein Ausführungsbeispiel eine Polymerstruktur aus einem dotierten Poly(3-Methylthiophen) hergestellt werden. Dabei besteht der erste Elektrolyt **92** aus einer Lösung von 0,03 $Et_4NBF_4$ in trockenem Propylencarbonat. Für den Polymerisationsprozess ist die Strukturelektrode **66** die Anode und die Gegenelektrode **94** die Kathode. Die Gegenelektrode **94** kann Platin aufweisen oder aus Platin sein. Beim Einschalten der Spannungsquelle **100** wird eine Spannung von beispielsweise 10 Volt zwischen der Strukturelektrode **66** und der Gegenelektrode **94** angelegt. Auf dem Elektrodenkontaktbereich **82** der Strukturelektrode **66** findet eine elektrochemische Polymerisation statt. Dabei scheidet sich ein leitfähiger Polymerfilm aus dotiertem Poly(3-Methylthiophen) mit einer Struktur entsprechend der vorgebbaren Struktur ab. Sobald der abgeschiedene Polymerfilm bzw. die Polymerstruktur die gewünschte Dicke von hier 0,2 mm aufweist (ca. nach 10 Sekunden), kann die Spannung abgeschaltet werden. Danach kann die Strukturelektrode **66** aus dem ersten Elektrolyten **92** herausgeholt werden. Die Strukturelektrode **66** mit dem auf ihrem Elektrodenkontaktbereich **82** gebildeten Polymerfilm (Polymerstruktur) **102** kann dann für weitere Verfahrensschritte verwendet werden.

In der Figur 5 ist der auf dem Elektrodenkontaktbereich **82** der Strukturelektrode **66** abgeschiedene Polymerfilm **102** dargestellt. Da der Elektrodenkontaktbereich **82** die vorgebbare Struktur aufweist, hat auch der abgeschiedene leitfähige Polymerfilm, also die Polymerstruktur **102,** die vorgebare Struktur. Denn der bei der Polymerisation fließende Strom fließt nur im Bereich des Elektrodenkontaktbereiches **82**. Es fließt kein Strom durch die nicht leitfähige Elektrodenoberflächenschicht **80** und/oder auch kein Strom im Elektrodenkomplementärbereich **84**. Im Elektrodenkomplementärbereich **84** findet deshalb auch keine elektrochemische Polymerisation statt. Deshalb wird hier auch kein Polymer aus dem ersten Elektrolyten abgeschieden. Die Struktur des Elektrodenkontaktbereiches **82** bestimmt deshalb auch die Struktur der Polymerstruktur **102.**

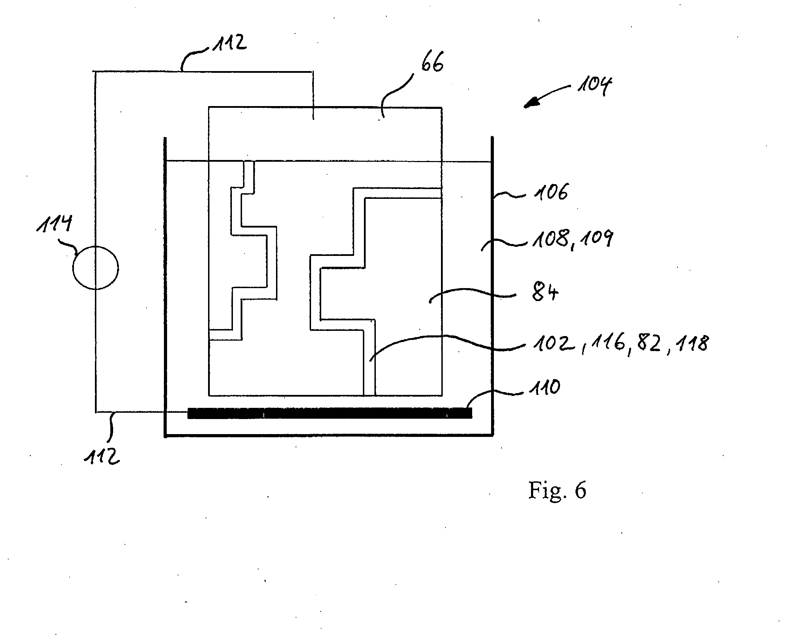

In Figur 6 ist eine schematische Darstellung einer Galvanikstation **104** zur Durchführung eines Galvanikprozesses gezeigt. Die Galvanikstation **104** weist einen Behälter **106** auf. In diesem Behälter **106** kann der zweite Elektrolyt **108** oder der dritte Elektrolyt **109** eingebracht sein. Das zweite Elektrolyt **108** weist Kupfer auf. In diesem Sinne kann der zweite Elektrolyt **108** ein Metallsalz, insbesondere Kupfersulfat ($CuSO_4$), aufweisen. Der dritte Elektrolyt **109** weist Silber oder eine Silberverbindung, insbesondere Nanosilber, auf. Außerdem ist eine Gegenelektrode **110** in den Behälter **106** eingebracht und/oder mit dem zweiten beziehungsweise dritten Elektrolyten **108** bzw. **109** in Kontakt gebracht.

Für den Primärgalvanikprozess wird die Polymerstruktur **102** mit dem zweiten Elektrolyten **108** in Kontakt gebracht. Die Polymerstruktur **102** kann dabei mit der Strukturelektrode **66** insbesondere auch elektrisch verbunden sein. Die Strukturelektrode **66** weist, wie bereits zu *Figur 3* und *Figur 5* erläutert, einen nicht leitfähigen Elektrodenkomplementärbereich **84** und einen elektrisch leitfähigen Elektrodenkontaktbereich **82** auf. Der Elektrodenkontaktbereich **82** ist außerdem mit einem elektrischen Potential der Spannungsquelle **114** verbunden. Somit ist auch die Polymerstruktur **102** mit dem elektrischen Potential der Spannungsquelle **114** verbunden. In dem Elektrodenkomplementärbereich **84** der Strukturelektrode **66** wird durch den Primärgalvanikprozess kein oder zumindest im Wesentlichen kein Metall abgeschieden. Die Abscheidung des ersten metallischen Stoffes erfolgt auf der Polymerstruktur **102.** Durch die Metallabscheidung entsteht auf der Polymerstruktur **102** eine Metallstruktur **116.**

Für den Sekundärgalvanikprozess wird die Metallstruktur **116** in den zweiten Elektrolyten **109** eingetaucht. Die Metallstruktur **116** wird also mit dem zweiten Elektrolyten **109** in Kontakt gebracht. Außerdem wird die Metallstruktur **116** mit einem elektrischen Potential der Spannungsquelle **114** verbunden. Diese Verbindung erfolgt mittels des Elektrodenkontaktbereiches **82** und der Polymerstruktur **102.** Denn der Elektrodenkontaktbereich **82** ist durch die Leitungsverbindungen **112** mit einem elektrischen Potential der Spannungsquelle **114** verbunden. Ferner ist der Elektrodenkontaktbereich **82** durch den Galvanisierungsprozess mit der Polymerstruktur **102** vorzugsweise auch elektrisch verbunden. Die Polymerstruktur **102** ist außerdem durch den Sekundärgalvanikprozess mit der Metallstruktur **116** elektrisch verbunden. Durch den Sekundärgalvanikprozess findet eine elektrolytische Metallabscheidung des zweiten metallischen Stoffes auf der Metallstruktur **116** statt, so dass die Kontaktmetallstruktur **118** auf der Metallstruktur **116** gebildet wird.

Grundsätzlich kann die Abscheidung des ersten oder zweiten metallischen Stoffes durch das Ein- oder Ausschalten der Spannungsquelle **114** gesteuert werden. Denn sowohl die Gegenelektrode **110** als auch die Polymerstruktur sind jeweils über elektrische Verbindungsleitungen **112** mit der Spannungsquelle **114** verbunden. Eine Abscheidung findet also nur statt, wenn die Spannungsquelle eingeschaltet ist und/oder eine Spannungsdifferenz zwischen der Gegenelektrode und der Polymerstruktur beziehungsweise der Metallstruktur hergestellt ist.

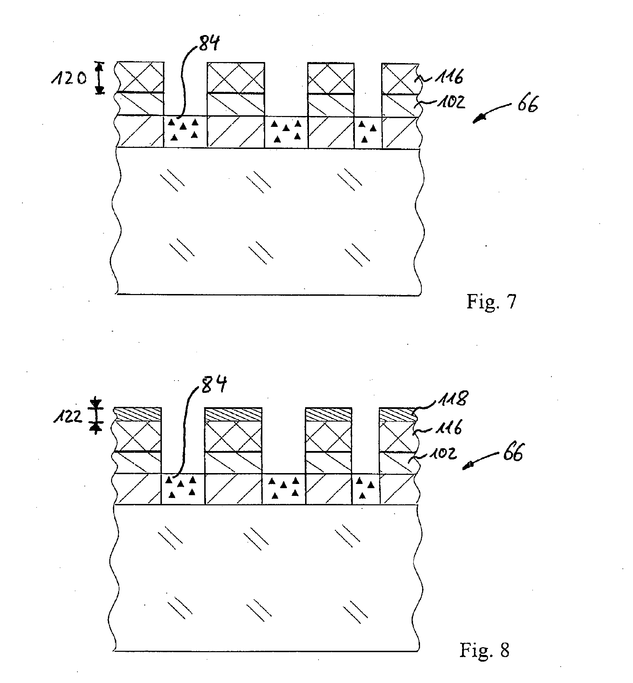

In der Figur 7 ist eine Schnittansicht einer Strukturelektrode **66** mit einer Polymerstruktur **102** und einer Metallstruktur **116** gezeigt. Durch den Primärgalvanikprozess wurde der erste metallische Stoff nur auf der Polymerstruktur **102** abgeschieden. Die Metallstruktur **116** erstreckt sich deshalb nicht oder zumindest im Wesentlichen nicht lateral über die Polymerstruktur **102** hinaus. In Abhängigkeit der Spannung und der Dauer des Anlegens der Spannung bei dem Primärgalvanikprozess weist die Metallstruktur **116** eine bestimmte Dicke **120** auf. Auf dem Elektrodenkomplementärbereich **84** der Strukturelektrode **66** ist durch den Primärgalvanikprozess zumindest im Wesentlichen kein Metall abgeschieden worden. Die Struktur der Polymerstruktur **102** prägt deshalb die Struktur der Metallstruktur **116.** Die Polymerstruktur **102** und die Metallstruktur **116** weisen zumindest im Wesentlichen die vorgebbare Struktur auf.

In der Figur 8 ist eine Schnittansicht einer Strukturelektrode 66 mit einer Polymerstruktur **102,** einer Metallstruktur **116** und einer Kontaktmetallstruktur **118** gezeigt. Durch den Sekundärgalvanikprozess wurde der zweite metallische Stoff insbesondere nur auf der Metallstruktur **116** abgeschieden. Die Kontaktmetallstruktur **118** erstreckt sich deshalb nicht oder zumindest im Wesentlichen nicht lateral über die Polymerstruktur **102** und/oder über die Metallstruktur **116** hinaus. In Abhängigkeit der Spannung und der Dauer des Anlegens der Spannung bei dem Sekundärgalvanikprozess weist die Kontaktmetallstruktur **118** eine bestimmte Dicke **122** auf. Auf dem Elektrodenkomplementärbereich **84** der Strukturelektrode **66** ist durch den Sekundärgalvanikprozess zumindest im Wesentlichen kein Metall abgeschieden worden. Die Struktur der Polymerstruktur **102** prägt deshalb die Struktur der Metallstruktur **116** und/oder der Kontaktmetallstruktur **118.** Die Polymerstruktur **102,** die Metallstruktur **116** und die Kontaktmetallstruktur **118** weisen zumindest im Wesentlichen die vorgebbare Struktur auf.

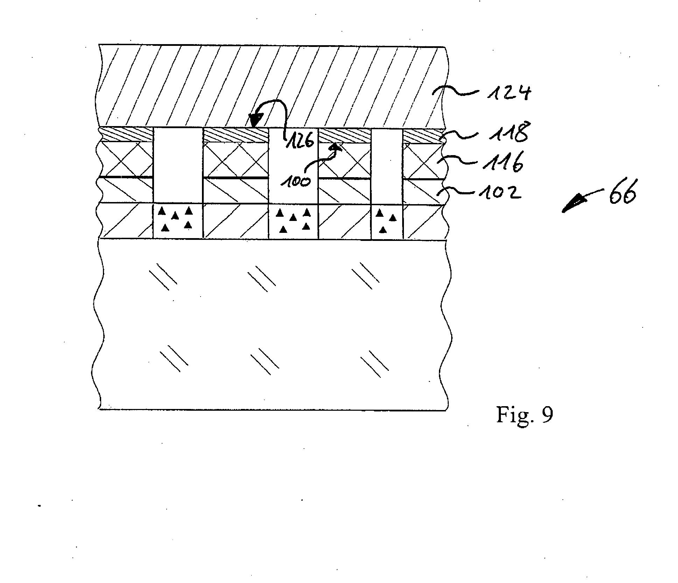

In der Figur 9 ist eine Schnittansicht einer Strukturelektrode **66** mit einer Polymerstruktur **102,** einer Metallstruktur **116** und einer Kontaktmetallstruktur **118** in Verbindung mit einem Substrat **124** gezeigt. Die Metallstruktur **116** ist durch die Kontaktmetallstruktur **118** auf der von der Polymerstruktur **102** abgewandten Seite **100** mit dem Substrat **124** verbunden. Das Substrat **124** ist also mit der Metallstruktur **116** durch die Kontaktmetallstruktur **118** zumindest auch elektrisch kontaktiert. Vor und/oder während des Kontaktieren des Substrates **124** mit der Kontaktmetallstruktur **118** wurde die Kontaktmetallstruktur **118** zumindest in dem von der Metallstruktur abgewandten Bereich **126** in einen flüssigen und/oder breiigen Aggregatzustand überführt. Das Substrat **124** wird also mit der flüssigen und/oder breiigen Kontaktmetallstruktur **118** in Kontakt gebracht. Danach wir der Kontaktmetallstruktur **118** Energie und/oder Wärme entzogen, so dass die Kontaktmetallstruktur **118** erstarrt und das Substrat **124** mit der Kontaktmetallstruktur **118** und/oder mit der Metallstruktur **116,** insbesondere haftend, verbunden wird. Vor dem Erstarren der Kontaktmetallstruktur werden die Metallstruktur **116** und das Substrat **124** zueinander positioniert. Die Positionierung erfolgt in der Weise, dass bestimmte, insbesondere zuvor bestimmte, Oberflächenbereiche des Substrat mit der Kontaktmetallstruktur elektrisch kontaktiert werden.

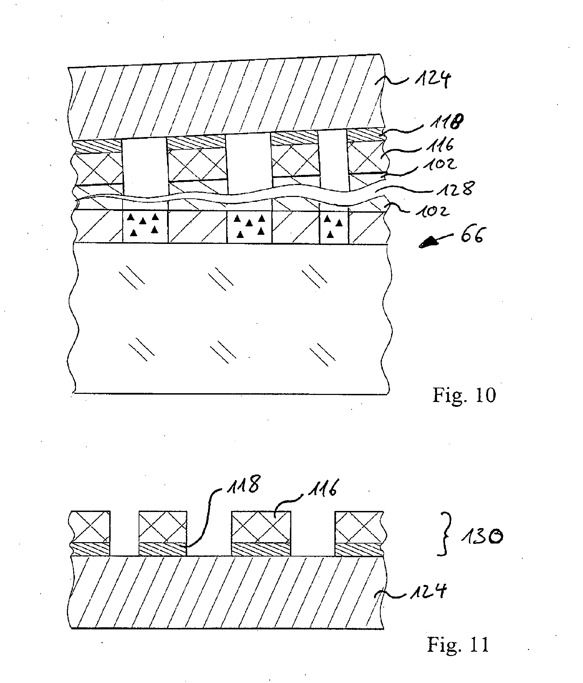

In der Figur 10 ist eine Schnittansicht einer Sollbruchstelle **128** durch die Polymerstruktur **102,** die zumindest teilweise mit den Substrat **124** und teilweise mit der Strukturelektrode **66** verbunden ist, dargestellt. Beispielsweise durch eine zumindest im Wesentlichen normale, nach außen gerichtete Krafteinwirkung auf das Substrat **124** und die Strukturelektrode **66** oder durch eine anders gerichtete Krafteinwirkung, etwa durch eine schräg nach außen gerichtete Abziehkraft, verursacht, kann die Polymerstruktur **102** als Sollbruchstelle **128** und/oder als Sollbruchschicht **128** wirken. Die Polymerstruktur **102** weist dazu eine geringere Festigkeit, insbesondere eine geringere spezifische Festigkeit, als die Metallstruktur **116,** die Kontaktmetallstruktur **118,** das Substrat **124** und/oder die Strukturelektrode **66** auf. Die Festigkeit und/oder spezifische Festigkeit kann auch die Bruchfestigkeit sein. Bei einer der zuvor genannten Krafteinwirkungen kann deshalb die Polymerstruktur wie in Figur 10 dargestellt winkelig aufbrechen. Die Polymerstruktur **102** kann dabei in mehrere Teile zerbrechen und/oder geteilt werden. So können Teile der Polymerstruktur **102** an der Strukturelektrode **66** und/oder an der Metallstruktur **116** haften bleiben. Die an der Metallstruktur **116** haftenden Teile der Polymerstruktur können nachträglich abgetrennt werden. Dazu können diese Teile der Polymerstruktur in den flüssigen und/oder gasförmigen Aggregatzustand überführt werden und/oder mechanisch, beispielsweise durch rakeln und/oder schleifen, abgetrennt werden.

Alternativ (nicht dargestellt) kann die Polymerstruktur **102** auch mit der Strukturelektrode **66,** insbesondere im Wesentlichen vollständig, von der Metallstruktur **116** getrennt werden. Dazu kann die Verbindung zwischen der Polymerstruktur **102** und der Metallstruktur **116** in der Weise ausgestaltet sein, dass es zur Trennung der beiden Strukturen einer Krafteinwirkung bedarf, die nicht ausreicht, um die Polymerstruktur **102** zu zerstören, zu zerbrechen und/oder zu zerreißen. Mit anderen Worten ist dazu die Bruchfestigkeit der Polymerstruktur **102** höher als die Festigkeit der Verbindung zwischen der Polymerstruktur **102** und der Metallstruktur **116.** Die Bruchfestigkeit der Polymerstruktur **102** und/oder die Festigkeit der Verbindung zwischen der Polymerstruktur **102** und der Metallstruktur **116** kann durch eine geeignete Wahl des Lösungsmittels des ersten Elektrolyten und/oder durch eine geeignete Wahl der polymerisier- und/oder verletzbaren Verbindungen des ersten Elektrolyten vorteilhaft bestimmt werden.

In der Figur 11 ist eine Schnittansicht einer Leiterbahn **130** auf einem Substrat **124** dargestellt. Die Leiterbahn wird durch die Metallstruktur **116** und die Kontaktmetallstruktur **118** gebildet. Die zuvor in Figur 10 noch mit der Metallstruktur **116** verbundene Polymerstruktur **102** wurde thermisch, chemisch und/oder mechanisch von der Metallstruktur **116** entfernt.

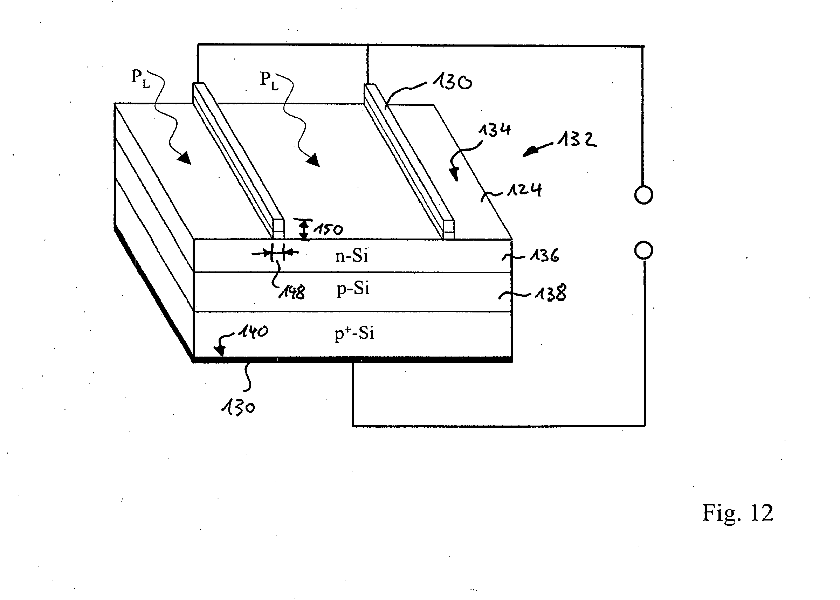

In der Figur 12 sind schematisch elektrisch leitende Leiterbahnen **130** auf einem Substrat **124** einer Solarzelle **132** dargestellt. Das Substrat **124** ist in mehrere Schichten unterteilt, wobei der Basisstoff des Substrats bevorzugt Silizium ist. Die oberste Schicht **136** des Substrat ist ein n-dotiertes Silizium (n-Si). Unterhalb der n-dotierten Siliziumschicht **136** weist das Substrat eine Schicht **138** aus p-dotiertem Silizium (p-Si) sowie unterhalb dieser eine Schicht aus p-hochdotiertem Silizium.

(p$^+$-Si) auf. Die dem p-Si gegenüberliegende Seite des n-Si bildet die Frontseite **134** der Solarzelle **132** und die dem n-Si gegenüberliegende Seite des p$^+$-Si bildet die Rückseite **140** der Solarzelle **132**. Die Frontseite **134** sowie die Rückseite **140** sind jeweils mit mehreren Leiterbahnen **130** kontaktiert. Um Strahlungsenergie, insbesondere Sonnenlicht, in elektrische Energie umzuwandeln, erzeugen die einstrahlende Photonen mit einer Lichtleistung P$_L$ bewegliche Ladungsträger (Löcher und Elektronen). Das Substrat **124** ist mit den Leiterbahnen **130** in der Weise elektrisch verbunden, dass die Ladungsträger zu dem elektrischen Schaltkreis außerhalb der Solarzelle geleitet wird. Damit außerdem möglichst viel Licht auf die Frontseite **134** der Solarzelle **132** treffen kann, weisen die Leiterbahnen **130** eine möglichst geringe Breite **148** auf. Die Dicke **150** einer Leiterbahn kann in Abhängigkeit des zu erwartenden Stroms durch die Solarzelle bestimmt sein.

**Patentansprüche**

1. Verfahren zur Herstellung mindestens einer Leiterbahn auf einem Substrat, **gekennzeichnet durch** die Verfahrensschritte:

   a. Erstellung einer elektrisch leitfähigen Polymerstruktur mittels elektrochemischer Polymerisation auf einer strukturierten Elektrode,
   b. ein erstes galvanisches Abscheiden eines ersten metallischen Stoffes auf zumindest einem Teil der Polymerstruktur, so dass eine erste Metallstruktur entsteht,
   c. ein zweites galvanisches Abscheiden eines zweiten metallischen Stoffes auf zumindest einem Teil der ersten Metallstruktur, so dass eine zweite Metallstruktur entsteht und
   d. ein thermisches Verbinden der ersten und/oder der zweiten Metallstruktur mit dem Substrat, wobei die mit dem Substrat verbundene Metallstruktur das Verbindungsmittel ist.

2. Verfahren nach einem der vorhergehenden Ansprüche, **dadurch gekennzeichnet, dass** das Substrat einen elektrisch halbleitenden Stoff und/oder eine Halbleiterstruktur aufweist und/oder ein Halbleitermaterial, insbesondere ein p-dotiertes oder n-dotiertes Halbleitermaterial, ist.

3. Verfahren nach einem der vorhergehenden Ansprüche, **dadurch gekennzeichnet, dass** der zweite metallische Stoff porös ist.

4. Verfahren nach einem der vorhergehenden Ansprüche, **dadurch gekennzeichnet, dass** der zweite metallische Stoff Partikel mit einem mittleren Durchmesser von höchstens 50 nm aufweist.

5. Verfahren nach einem der vorhergehenden Ansprüche, **dadurch gekennzeichnet, dass** ein Oberfläche-zu-Volumen-Verhältnis (AN-Verhältnis) von der Kontaktmetallstruktur größer ist, insbesondere deutlich größer ist, als das von der Metallstruktur.

6. Verfahren nach einem der vorhergehenden Ansprüche, **dadurch gekennzeichnet, dass** die Kontaktmetallstruktur auf eine Temperatur erwärmt wird, die oberhalb der Schmelztemperatur des zweiten metallischen Stoffs ist und/oder die unterhalb der Schmelztemperatur des ersten metallischen Stoffs, des Substrats und/oder der Polymerstruktur ist.

7. Verfahren nach einem der vorhergehenden Ansprüche, **dadurch gekennzeichnet, dass** der zweite metallische Stoff in der Weise gewählt ist, dass eine Austrittsarbeit der Elektronen der Kontaktmetallstruktur kleiner oder gleich einer Elektronenaffinität des Substrats ist.

8. Verfahren nach einem der vorhergehenden Ansprüche, **dadurch gekennzeichnet, dass** eine Leiterbahn eine Breite von 5 bis 200 $\mu$m aufweist.

9. Verfahren nach einem der vorhergehenden Ansprüche, **dadurch gekennzeichnet, dass** eine Leiterbahn eine Dicke von 5 bis 200 $\mu$m aufweist.

10. Verfahren nach einem der vorhergehenden Ansprüche, **dadurch gekennzeichnet, dass** die für eine weitere Kontaktierung vorgesehene Metallstruktur eine Dikke von 100 nm bis 5 $\mu$m aufweist.

11. Verfahren nach einem der vorhergehenden Ansprüche, **dadurch gekennzeichnet, dass** eine Anordnung wenigstens zweier Leiterbahnen und/oder die Querschnittsfläche der ersten metallischen Schicht und/oder der Leiterbahn unter Zugrundelegung eines maximal für eine geplante Anwendung des Substrats mit Leiterbahn zulässigen elektrischen Widerstands der ersten metallischen Schicht und/oder der Leiterbahn festgelegt wird.

Fig. 1

Fig. 2

Fig. 3

EP 2 290 134 A1

Fig. 4

Fig. 5

Fig. 6

EP 2 290 134 A1

Fig. 7

Fig. 8

Fig. 9

124

118
116
102
128
102

66

Fig. 10

118    116

130

124

Fig. 11

EP 2 290 134 A1

P_L

P_L

130

134

132

124

150

n-Si — 136

148  p-Si — 138

140  p⁺-Si

130

Fig. 12

Europäisches
Patentamt

European
Patent Office

Office européen
des brevets

**EUROPÄISCHER RECHERCHENBERICHT**

**Nummer der Anmeldung**

EP 09 01 0995

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 1 289 031 A2 (UNIV BRAUNSCHWEIG TECH [DE]) 5. März 2003 (2003-03-05) * Absätze [0010] - [0013], [0019], [0037] * ----- | 1-11 | INV. C25D13/04 C25D5/10 C25D5/50 C25D5/56 H01L31/0224 H01L21/288 C09D5/44 H05K3/20 C25D1/04 C25D1/22 |
| A,D | DE 11 2004 000600 T5 (SUNPOWER CORP.) 16. Februar 2006 (2006-02-16) * das ganze Dokument * ----- | 1-11 | |

RECHERCHIERTE
SACHGEBIETE (IPC)

H05K
C25D

Der vorliegende Recherchenbericht wurde für alle Patentansprüche erstellt

| Recherchenort | Abschlußdatum der Recherche | Prüfer |
|---|---|---|
| Den Haag | 13. Juli 2010 | Le Hervet, Morgan |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
.......................................................................................................
& : Mitglied der gleichen Patentfamilie, übereinstimmendes
    Dokument

**ANHANG ZUM EUROPÄISCHEN RECHERCHENBERICHT
ÜBER DIE EUROPÄISCHE PATENTANMELDUNG NR.**

EP 09 01 0995

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

13-07-2010

| Im Recherchenbericht angeführtes Patentdokument | Datum der Veröffentlichung | Mitglied(er) der Patentfamilie | Datum der Veröffentlichung |
|---|---|---|---|
| EP 1289031 A2 | 05-03-2003 | DE 10140666 A1<br>US 2003052015 A1 | 13-03-2003<br>20-03-2003 |
| DE 112004000600 T5 | 16-02-2006 | JP 2006523025 T<br>US 2008210301 A1<br>US 2004200520 A1<br>WO 2004095587 A2 | 05-10-2006<br>04-09-2008<br>14-10-2004<br>04-11-2004 |

EPO FORM P0461

Für nähere Einzelheiten zu diesem Anhang : siehe Amtsblatt des Europäischen Patentamts, Nr.12/82

**EP 2 290 134 A1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 112004000600 T5
- DE 102009010434